# EUROPEAN PATENT SPECIFICATION

(11) **EP 1 049 117 B1**
(45) Date of publication and mention of the grant of the patent: **02.11.2011**
(21) Application number: 00108862.4
(22) Date of filing: 26.04.2000
(51) Int. Cl.: C07F 15/00, H01G 9/20, H01L 51/46

(54) **Ruthenium complex dye**
Rutheniumkomplex-Farbstoff
Colorant de complexes de ruthenium

(30) Priority: 26.04.1999 JP 11782899; 14.06.1999 JP 16756499; 28.12.1999 JP 37560999
(43) Date of publication of application: 02.11.2000
(60) Divisional application: 10014756.0
(73) Proprietor: FUJIFILM Corporation, Minato-ku Tokyo (JP)
(72) Inventor: Takizawa, Hiroo, Minami-Ashigara-shi, Kanagawa-ken (JP); Kubota, Tadahiko, Minami-Ashigara-shi, Kanagawa-ken (JP)
(74) Representative: Grünecker, Kinkeldey, Stockmair & Schwanhäusser

(56) References cited:
- WO-A-97/11955
- WO-A-98/50393
- WO-A1-94/04497
- KALYANASUNDARAM K ET AL: "APPLICATIONS OF FUNCTIONALIZED TRANSITION METAL COMPLEXES IN PHOTONIC AND OPTOELECTRONIC DEVICES" COORDINATION CHEMISTRY REVIEWS, ELSEVIER SCIENCE, AMSTERDAM, NL, vol. 177, 1998, pages 347-414, XP000890182 ISSN: 0010-8545
- JURIS A ET AL: "RU(II) POLYPYRIDINE COMPLEXES: PHOTOPHYSICS, PHOTOCHEMISTRY, ELECTROCHEMISTRY AND CHEMILUMINESCENCE" COORDINATION CHEMISTRY REVIEWS, ELSEVIER SCIENCE, AMSTERDAM, NL, vol. 84, 1988, pages 85-277, XP008007404 ISSN: 0010-8545
- M. K. NAZEERUDDIN, ET AL.: J. CHEM. SOC. DALTON TRANS., 1997, pages 4571-4578,
- S. RUIL ET AL.: INORG. CHIMICA ACTA, vol. 261, 1997, pages 129-140,

## Description

### BACKGROUND OF THE INVENTION

The present invention relates to a metal complex dye that is able to efficiently sensitize semiconductor particles, a photoelectric conversion device comprising semiconductor particles sensitized by the metal complex dye, and a photo-electrochemical cell comprising the photoelectric conversion device.

Solar cells for the solar power generation comprising a monocrystalline silicon, a polycrystalline silicon, an amorphous silicon, cadmium telluride, indium copper selenide, etc. have been the subject of practical use and a major object of research and development. However, for a widespread use of the solar cell as a home power source, etc., there are such problems as a high production cost, difficulty in security of raw materials, and a long energy payback time, therefore, these obstacles must be overcome. On the other hand, a variety of solar cells comprising organic materials are proposed with the objects of increasing the surface area of the cell, lowering the price thereof, etc. However, they generally have such defects as a low conversion efficiency and a poor durability.

Under these circumstances, Nature, vol. 353, pp. 737 to 740 (1991), United States Patent No. 4,927,721 and WO 94/04497 proposed a wet-type photoelectric conversion device and a solar cell each comprising a titanium dioxide porous thin film spectrally sensitized with a ruthenium complex dye as a working electrode, and materials and a production technique for making the same. The primary advantage for the wet-type device is that a low-priced photoelectric conversion device can be provided because an inexpensive oxide semiconductor such as titanium dioxide can be used without purification thereof to a high purity. The secondary advantage therefor is that a light in almost whole visible wavelength region can be converted to electricity because the dye used therein exhibits a broad absorption spectrum.

Known ruthenium complex dye mentioned above have a thiocyanate group or an isothiocyanate group as a ligand. These groups are liable to be de-sulfurized by heat or light, to be converted into a cyano group. Consequently, it has been known that for the photoelectric conversion device comprising the ruthenium complex dye with these groups, a photoelectric conversion efficiency tends to be reduced by heat or light. Accordingly, for improvement of the photoelectric conversion device in stability to heat and light, it has been desired to develop a ligand exhibiting a higher stability to heat and light than those of the thiocyanate group and the isothiocyanate group.

On the other hand, known ruthenium complex dyes are disadvantageous in hardly absorbing an infrared ray with a wavelength of 700 nm or more. Consequently, a photoelectric conversion device comprising such a dye exhibits a low photoelectric conversion efficiency at infrared region. Accordingly, it has been desired to develop a dye having a high absorbancy at a large wave range containing visible region to infrared region.

A. Juris et al., Coord. Chem. Rev. 84 (1988) 85-277 describes Ru(II) polypyridine complexes and their role in photophysics, photochemistry, electrochemistry and chemiluminescence.

WO97/11955A discloses a process for the preparation of inorganic dyes useful as spectral sensitizers for semiconductors, wherein the intermediate Ru(dcb)₂(C₂O₄)⁴⁻ is present.

WO98/50393 describes photosensitizer Ru, Os, Fe, Re and Tc complexes having an enhanced response in the red and near infrared regions.

M. K. Nazeeruddin et al., J. Chem. Soc. Dalton Trans. 1997, 4571-4578 describes Ru(II) polypyridyl complexes and their application in solar energy conversion.

S. Ruile et al., Inorg. Chem. Acta 261 (1997) 129-140 discloses Ru(II) complexes containing 2,6-bis(methybenzimidazol-2-yl)pyridine applied as sensitizers in photovoltaic cells.

### OBJECT AND SUMMARY OF THE INVENTION

The first object of the present invention is to provide a metal complex dye having a high stability to heat and light which is able to efficiently sensitize semiconductor particles, a photoelectric conversion device comprising the metal complex dye which exhibits a high stability to heat and light, and an excellent photoelectric conversion efficiency, and a photo-electrochemical cell comprising the photoelectric conversion device.

The second object of the present invention is to provide a metal complex dye having a high absorbability not only at visible region but also at infrared region, which is able to efficiently sensitize semiconductor particles, a photoelectric conversion device comprising the metal complex dye which exhibits an excellent photoelectric conversion efficiency, and a photo-electrochemical cell comprising the photoelectric conversion device.

As a result of intense research in view of the above first object, the inventors have found that a metal complex dye comprising a metal atom, bidentate or tridentate ligand(s) having nitrogen atoms for coordinating to the metal atom, and monodentate or bidentate ligand(s) which coordinates to the metal atom via one or two groups with an excellent stability to heat and light such as an acyloxy group, a 1,3-diketo group, etc. has a high stability to heat and light, and can efficiently sensitize semiconductor particles, and that a photoelectric conversion device comprising the metal complex dye exhibits a high stability to heat and light, and an excellent photoelectric conversion efficiency, so that it is useful for a photo-electrochemical cell. The first present invention has been accomplished by the findings.

Thus, in the first aspect of the present invention, there is provided a metal complex according of claim 1.

### BRIEF DESCRIPTION OF THE DRAWINGS

Fig. 1 is a partial cross sectional view showing a preferable structure of a photoelectric conversion device of the present invention,
Fig. 2 is a partial cross sectional view showing a preferable structure of a photoelectric conversion device of the present invention,

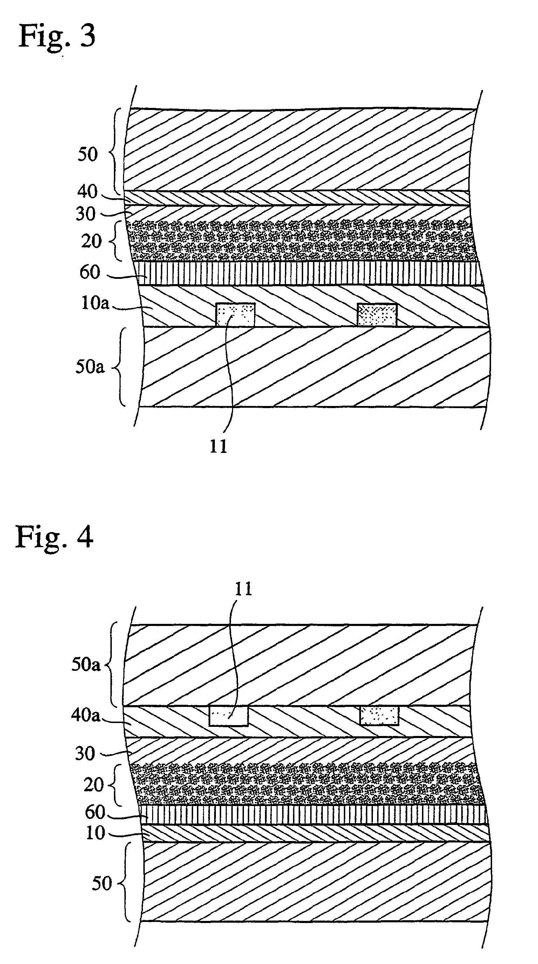

Fig. 3 is a partial cross sectional view showing a preferable structure of a photoelectric conversion device of the present invention,
Fig. 4 is a partial cross sectional view showing a preferable structure of a photoelectric conversion device of the present invention,

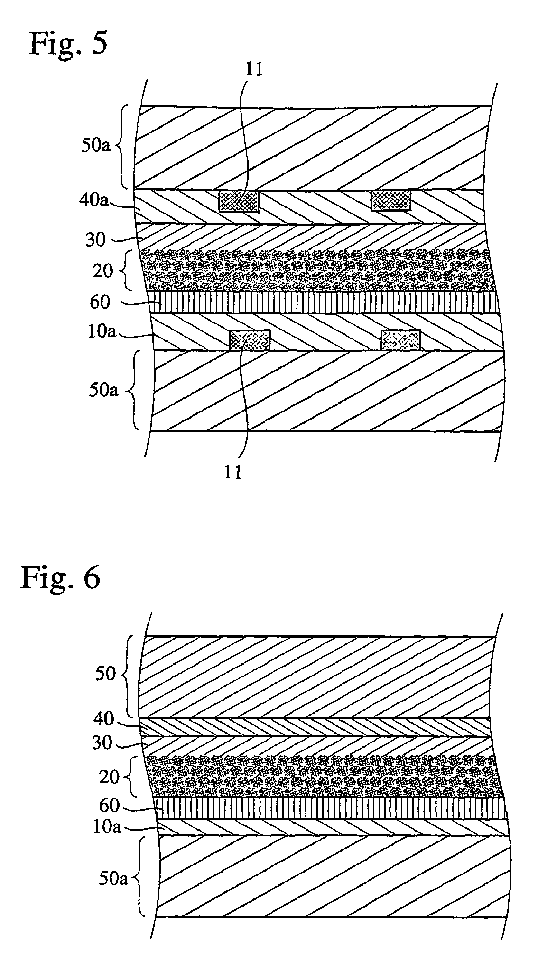

Fig. 5 is a partial cross sectional view showing a preferable structure of a photoelectric conversion device of the present invention,
Fig. 6 is a partial cross sectional view showing a preferable structure of a photoelectric conversion device of the present invention,

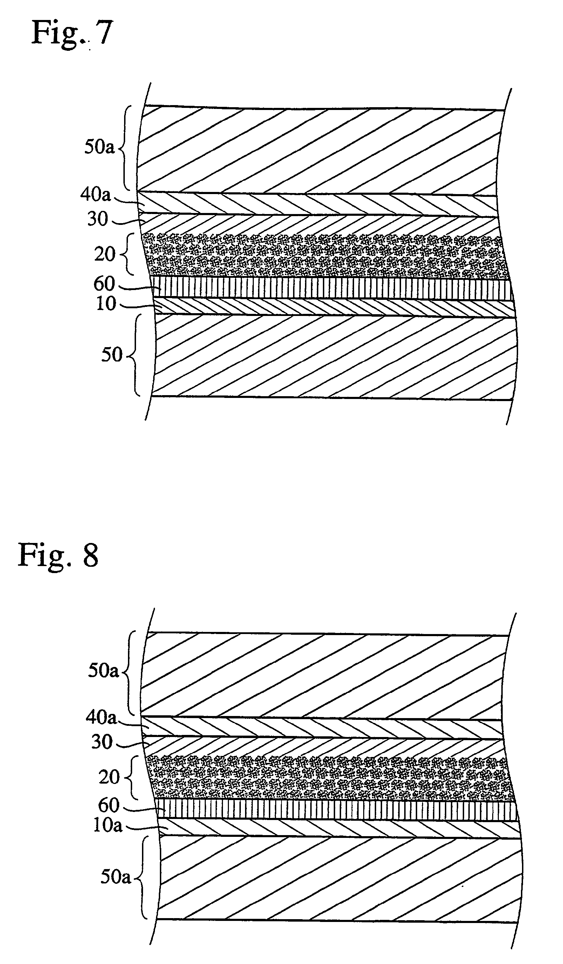

Fig. 7 is a partial cross sectional view showing a preferable structure of a photoelectric conversion device of the present invention,
Fig. 8 is a partial cross sectional view showing a preferable structure of a photoelectric conversion device of the present invention,

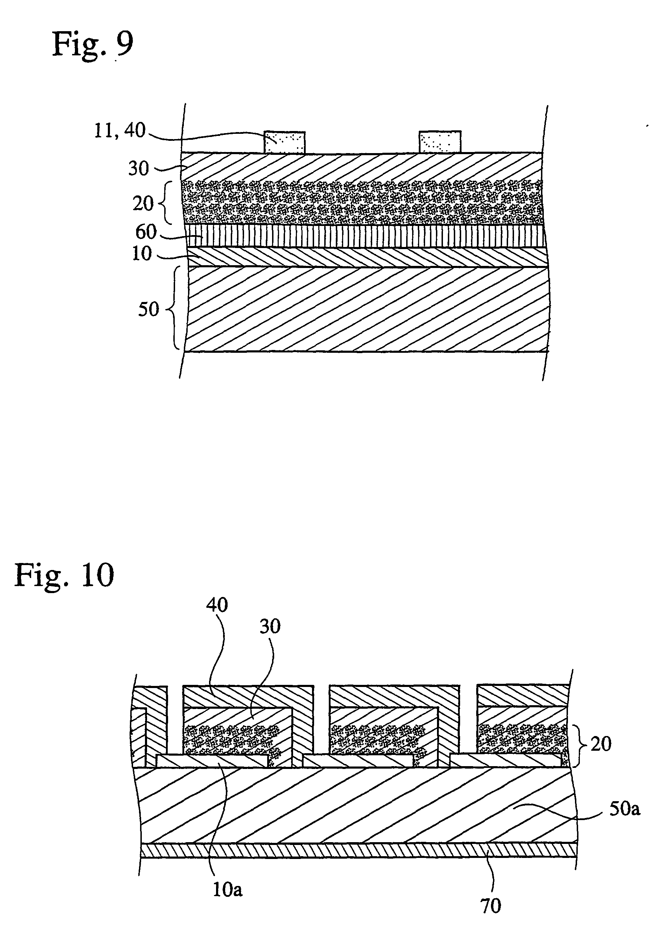

Fig. 9 is a partial cross sectional view showing a preferable structure of a photoelectric conversion device of the present invention, and
Fig. 10 is a partial cross sectional view showing an example of a structure of a substrate-integrated type solar cell module comprising a metal complex dye of the present invention.

### DETAILED DESCRIPTION OF THE PREFERRED EMBODIMENTS

### [1] Metal complex dye

A metal complex dye represented by the following general formula (II):

M₂(LL₂)m₃(LL₃)m₄(X₂)m₅•Cl₂ (II)

wherein M₂ is Ru;
LL₂ represents a bidentate ligand represented by any one of the following general formulae (V-1), (V-3) and (V-6):

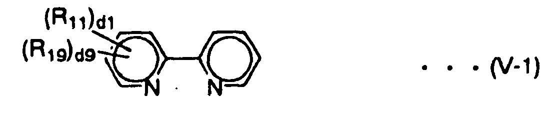

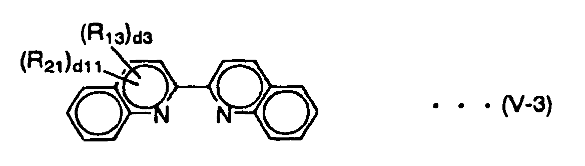

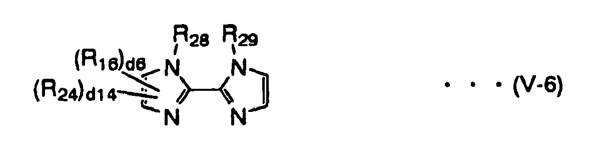

In the general formulae (V-1), (V-3), and (V-6) R₁₁ to R₁₈ independently represent a carboxyl group, a sulfonic acid group, a hydroxyl group, a hydroxamic acid group preferably having 1 to 20 carbon atoms such as - CONHOH, -CONCH₃OH, etc., a phosphoryl group such as -OP(O)(OH)₂, etc. or a phosphonyl group such as -P(O)(OH)₂, etc. Of these groups, preferred are a carboxyl group, a phosphonyl group and a phosphoryl group, more preferred are a carboxyl group and a phosphonyl group, and the most preferred is a carboxyl group.

In the general formulae (V-1), (V-3), and (V-6) R₁₉ to R₂₆ independently represent a substituent. Preferred examples thereof include an alkyl group preferably having 1 to 20 carbon atoms such as a methyl group, an ethyl group, an isopropyl group, a t-butyl group, a pentyl group, a heptyl group, a 1-ethylpentyl group, a benzyl group, a 2-ethoxyethyl group, a 1-carboxymethyl group, etc., an alkenyl group preferably having 2 to 20 carbon atoms such as a vinyl group, an allyl group, an oleyl group, etc., a cycloalkyl group preferably having 3 to 20 carbon atoms such as a cyclopropyl group, a cyclopentyl group, a cyclohexyl group, a 4-methylcyclohexyl group, etc., an aryl group preferably having 6 to 26 carbon atoms such as a phenyl group, a 1-naphthyl group, a 4-methoxyphenyl group, a 2-chlorophenyl group, a 3-methylphenyl group, etc., a heterocyclic group preferably having 2 to 20 carbon atoms such as a 4-pyridyl group, a 1-imidazolyl group, a 2-benzoimidazolyl group, a 2-thiazolyl group, a 2-oxazolyl group, etc., an alkoxy group preferably having 1 to 20 carbon atoms such as a methoxy group, an ethoxy group, an isopropyloxy group, a benzyloxy group, etc., an aryloxy group preferably having 6 to 26 carbon atoms such as a phenoxy group, a 1-naphthyloxy group, a 2-naphthyloxy group, a 4-methoxyphenoxy group, a 3-methylphenoxy group, etc., an acyloxy group preferably having 1 to 20 carbon atoms such as an acetyloxy group, a benzoyloxy group, etc., an alkoxycarbonyl group preferably having 2 to 20 carbon atoms such as an ethoxycarbonyl group, a 2-ethylhexyloxycarbonyl group, etc., a carbamoyl group preferably having 1 to 20 carbon atoms such as an N,N-dimethylcarbamoyl group, an N-phenylcarbamoyl group, etc., an acylamino group preferably having 1 to 20 carbon atoms such as an acetylamino group, a benzoylamino group, etc., an amino group preferably having 0 to 20 carbon atoms such as an amino group, an N,N-dimethylamino group, an N,N-diethylamino group, an N-ethylamino group, an anilino group, etc., an acyl group preferably having 1 to 20 carbon atoms such as an acetyl group, a benzoyl group, etc., a sulfonamido group preferably having 0 to 20 carbon atoms such as an N,N-dimethylsulfonamido group, an N-phenylsulfonamido group, etc., a cyano group, a hydroxyl group, or a halogen atom such as a fluorine atom, a chlorine atom, a bromine atom, an iodine atom, etc. Among them, more preferred are an alkyl group, an alkenyl group, an aryl group, a heterocyclic group, an alkoxy group, an alkoxycarbonyl group, an acylamino group, an amino group and a halogen atom, and particularly preferred are an alkyl group, an alkenyl group, an alkoxy group, an alkoxycarbonyl group, an acylamino group and an amino group.

In the general formulae (V-1), (V-3), and (V-6), R₂₇ to R₃₁ independently represent an alkyl group, an alkenyl group, an aryl group or a hydrogen atom. Preferable examples of these groups are equal to those of R₁₉ to R₂₆. R₂₇ to R₃, are preferably a branched alkyl group or an alkyl group having a carboxyl group, independently. Incidentally, when LL₁ contains an alkyl group, an alkenyl group, etc., they may be a substituted or unsubstituted group that may have a straight or branched structure.

Further, when LL₁ contains an aryl group, a heterocyclic group, etc., they may be a substituted or unsubstituted group that may have a monocyclic or condensed ring structure.

R₁₁ to R₂₆ may be bonded to any carbon atom forming a ring. d1 to d8, d13, d14 and d16 independently represent an integer of 0 to 4, and d9 to d12 and d15 independently represent an integer of 0 to 6. d1 to d5 are preferably 1 or 2, more preferably 2. d6 is preferably an integer of 0 to 2, d7 is preferably an integer of 1 to 3, and d8 is preferably an integer of 0 to 3. Further, d9 to d16 are preferably an integer of 0 to 2.

When d1 to d8 are 2 or more, R₁₁ to R₁₈ may be the same or different group, respectively. When d9 to d16 are 2 or more, R₁₉ to R₂₆ may be the same or different groups that may be bonded together to form a ring, respectively. It is particularly preferable that R₁₉'s, R₂₀'s, R₂₁'s and R₂₅'s are independently an alkyl group or an alkenyl group, and they are bonded together to form a ring when d9, d10, d11 and d15 are 2 or more, respectively.

Specific examples L-1 to- L-89 of the ligand LL₂ will be illustrated below without intention of restricting the scope of the present invention defined by the claims attached hereto.

| | | | |
|---|---|---|---|
| L-1 | 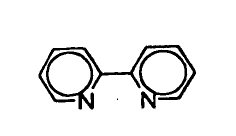 | L-2 | 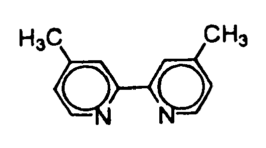 |
| L-3 | 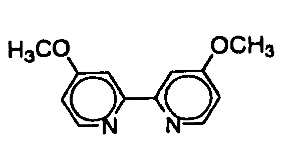 | L-4 | 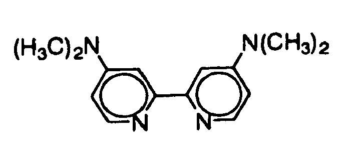 |
| L-5 | 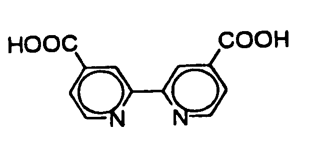 | L-6 | 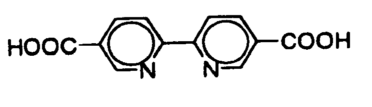 |
| L-7 | 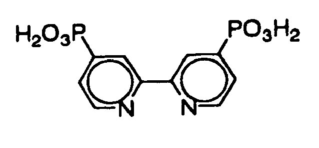 | L-8 | 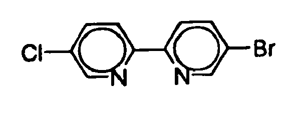 |
| L-9 | 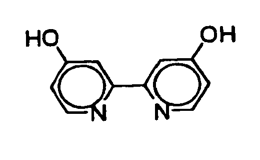 | L-10 | 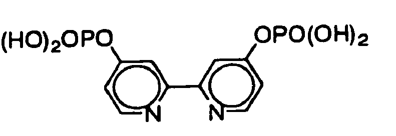 |
| L-11 | 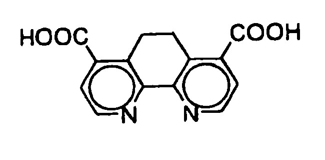 | L-12 | 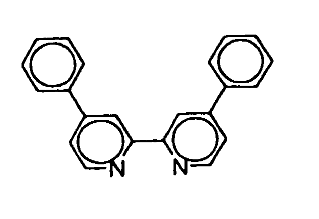 |
| L-13 | 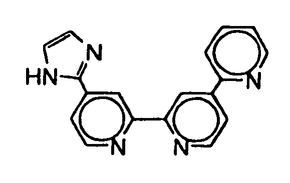 | L-14 | 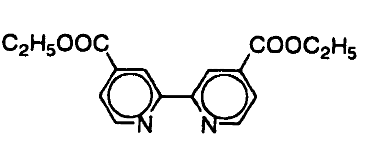 |
| L-15 | 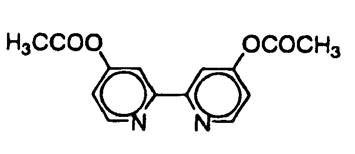 | L-16 | 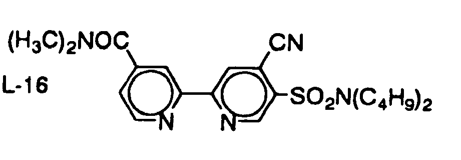 |
| L-17 | 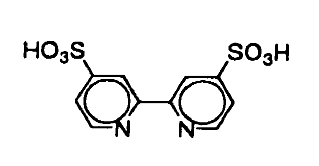 | L-18 | 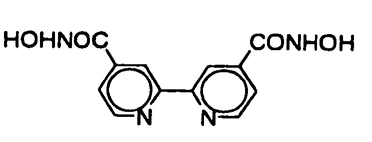 |
| L-19 | 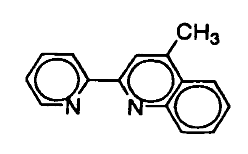 | L-20 | 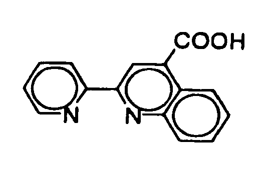 |
| | | L-24 | 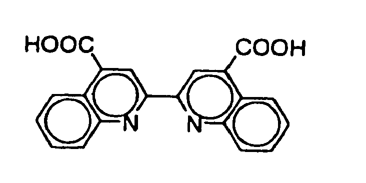 |
| L-25 | 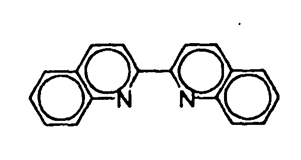 | L-26 | 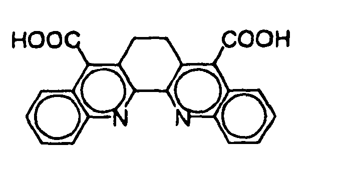 |
| L-31 | 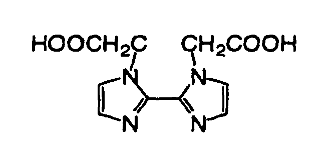 | L-32 | 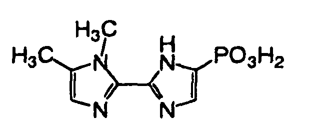 |
| L-33 | 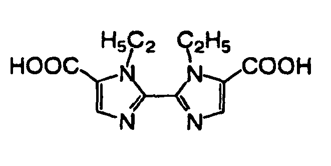 | | |
| | | L-42 | 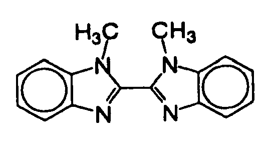 |
| L-43 | 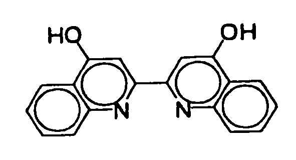 | L-44 | 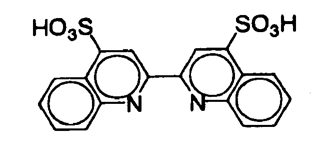 |
| L-45 | 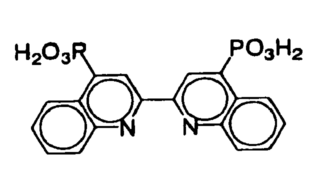 | L-46 | 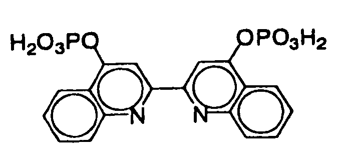 |
| L-47 | 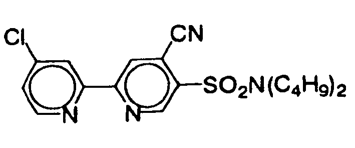 | L-48 | 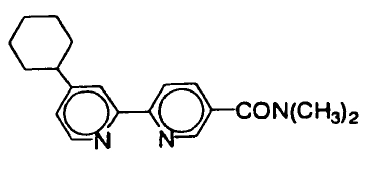 |
| L-50 | 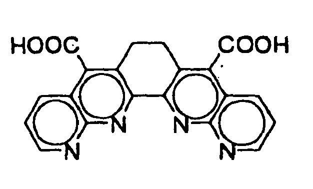 | | |
| L-52 | 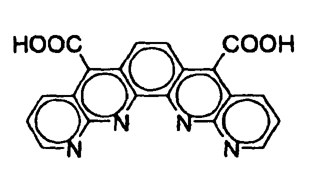 | | |
| L-54 | 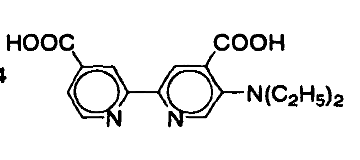 | | |

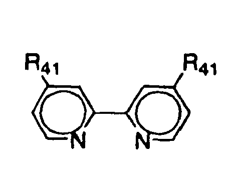

| | R₄₁ |
|---|---|
| L-57 | -OC₂H₅ |
| L-58 | -N(C₄H₉)₂ |
| L-59 | Br |

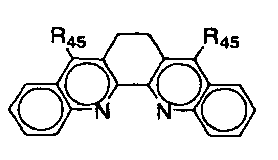

| | R₄₅ |
|---|---|
| L-64 | H |
| L-65 | -CH₃ |

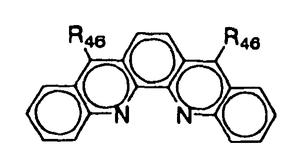

| | R₄₆ |
|---|---|
| L-66 | H |
| L-67 | -CH₃ |
| L-68 | -P0₃H₂ |

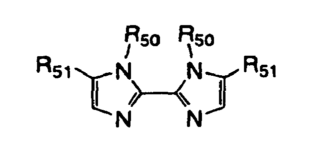

| | R₅₀ | R₅₁ |
|---|---|---|
| L-71 | H | H |
| L-72 | -CH₃ | H |
| L-73 | H | -COOH |
| L-74 | -(CH₂)₂PO₃H₂ | H |

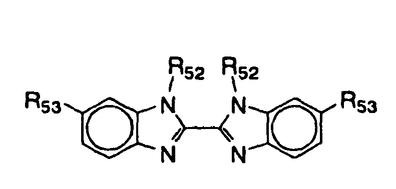

| | R₅₂ | R₅₃ |
|---|---|---|
| L-75 | H | H |
| L-76 | -C₄H₉ | -COOH |
| L-77 | -CH₂COOH | H |
| L-78 | -CH₂P0₃H₂ | H |

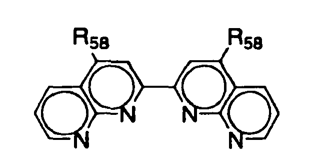

| | R₅₈ |
|---|---|
| L-86 | H |
| L-87 | -CH₃ |
| L-88 | -COOH |
| L-89 | -P0₃H₂ |

### (3) Ligand X₁

In the general formula (I), X₁ represents a monodentate or bidentate ligand which coordinates to M₁ via one or two groups selected from the group consisting of an acyloxy group preferably having 1 to 20 carbon atoms such as an acetyloxy group, a benzoyloxy group, a glycyloxy group, an N,N-dimethylglycyloxy group, a salicyloyloxy group, a oxalylene group (-OC(O)C(O)O-), etc., an acylthio group preferably having 1 to 20 carbon atoms such as an acetylthio group, a benzoylthio group, etc., an acylaminooxy group preferably having 1 to 20 carbon atoms such as an N-methylbenzoylaminooxy group (PhC(O)N(CH₃)O-), an acetylaminooxy group (CH₃C(O)NHO-), etc., a thioacyloxy group preferably having 1 to 20 carbon atoms such as a thioacetyloxy group (CH₃C(S)O-), etc., a thioacylthio group preferably having 1 to 20 carbon atoms such as a thioacetylthio group (CH₃C(S)S-), a thiobezoylthio group (PhC(S)S-), etc., a thiocarbonate group preferably having 1 to 20 carbon atoms such as ethylthiocarbonate, etc., a dithiocarbonate group preferably having 1 to 20 such as an ethyldithiocarbonate group (C₂H₅OC(S)S-), a phenydithiocarbonate group (PhOC(S)S-), etc., a trithiocarbonate group preferably having 1 to 20 carbon atoms such as an ethyltrithiocarbonate group (C₂H₅SC(S)S-), a phenyltrithiocarbonate group (PhSC(S)S-), etc., an alkylthio group preferably having 1 to 20 carbon atoms such as a methylthio group, an ethylenedithio group, etc., an arylthio group preferably having 6 to 20 carbon atoms such as a phenylthio group, a 1,2-phenylenedithio group, etc., an alkoxy group preferably having 1 to 20 carbon atoms such as a methoxy group, an ethylenedioxy group, etc., and an aryloxy group preferably having 6 to 20 carbon atoms such as a phenoxy group, a 1,2-benzenedioxy group, an 8-quinolyloxy group, etc., or a monodentate or bidentate ligand selected from the group consisting of ketones preferably being dialkylketones or 1,3-diketones preferably having 3 to 20 carbon atoms such as dimethylketone ((CH₃)₂CO···), acetylacetone (CH₃C(O-)=CH-C(O···)CH₃), trifluoroacetylacetone (CF₃C(O-)=CH-C(O ···)CH₃), dipivaloylmethane (t-C₄H₉C(O-)=CH-C(O...)-t-C₄H₉), dibenzoylmethane (PhC(O-)=CH-C(O···)Ph), 3-chloroacetylacetone (CH₃C(O-)=CCl-C(O···)CH₃), etc., carbonamides preferably having 1 to 20 carbon atoms such as CH₃N=C(CH₃)O-, -OC(=NH)-C(=NH)O-, etc., thiocarbonamides preferably having 1 to 20 carbon atoms such as CH₃N=C(CH₃)S-, etc., thioureas preferably having 1 to 20 atoms such as ···NH₂-C(S···)NH₂, ···N(CH₃)₂-C(S···)N(CH₃)₂, etc., and isothioureas preferably having 1 to 20 carbon atoms such as ···NH=C(S-)NH₂, ... N(CH₃)=C(S-)NHCH₃, etc. Incidentally,··· indicates a coordinate bond. m2 indicating the number of X₁ is an integer of 1 to 3. When m2 is 2 or 3, X₁'s may be the same or different ligands that may be bonded together.

X₁ is preferably a monodentate or bidentate ligand which coordinates to M₁ via one or two groups selected from the group consisting of an acyloxy group, an acylaminooxy group, an alkylthio group, an arylthio group, an alkoxy group and an aryloxy group, or a monodentate or bidentate ligand selected from the group consisting of ketones, thiocarbonamides, thioureas and isothioureas, more preferably a ligand which coordinates to M₁ via one or two groups selected from the group consisting of an acyloxy group, an acylaminooxy group, an alkylthio group and an arylthio group, or a 1,3-diketone, particularly preferably a ligand which coordinates to M₁ via an acyloxy group or an acylaminooxy group, or a 1,3-diketone.

When X₁ contains an alkyl group, an alkenyl group, an alkynyl group, an alkylene group, etc., they may be a substituted or unsubstituted group that has a straight or branched structure. When X₁ contains an aryl group, a heterocyclic group, a cycloalkyl group, etc., they may be a substituted or unsubstituted group that may have a monocyclic or condensed ring structure.

X₁ is preferably a bidentate ligand, more preferably a bidentate ligand represented by any one of the following general formulae (VI-1) to (VI-5). 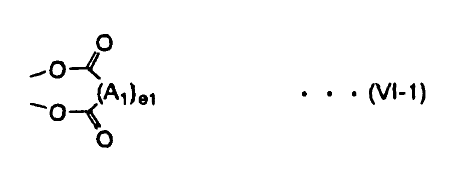 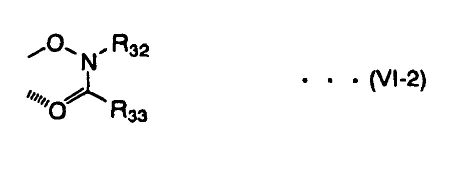 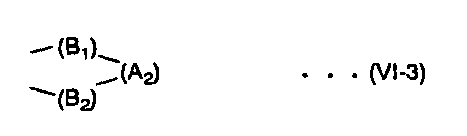 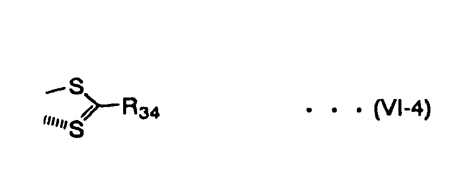 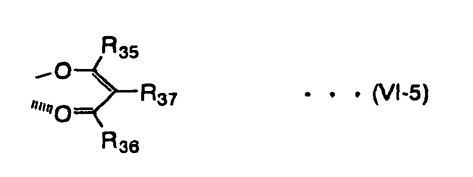 X₁ is furthermore preferably represented by any one of the general formulae (VI-1) to (VI-3) and (VI-5), particularly preferably represented by the general formulae (VI-1), (VI-2) or (VI-5), most preferably represented by the general formula (VI-5).

In general formula (VI-1), A₁, represents a bidentate linking group. At is preferably a bidentate linking group having 0 to 20 carbon atoms such as a methylene group, an ethylene group, a buthylene group, a 1-octylmethylene group, a 1,2-phenylene group, -NH-, etc., more preferably a linking group having 1 to 4 carbon atoms. Among them, A₁ is particularly preferably a methylene group or an ethylene group. el is 0 or 1, preferably 0. When el is 0, the general formula (VI-1) represents an oxalylene group.

In the general formula (VI-2), R₃₂ and R₃₃ independently represent an alkyl group, an alkenyl group, a cycloalkyl group, an aryl group, a heterocyclic group, an alkoxy group, an alkoxycarbonyl group, an amino group, an acyl group or a hydrogen atom. Preferable examples of these groups are the same as those of R₁₉ to R₂₆. R₃₂ is preferably an alkyl group, an alkenyl group, a cycloalkyl group, an aryl group, a heterocyclic group, an alkoxy group or an amino group, more preferably an alkyl group or an aryl group. R₃₃ is preferably an alkyl group, an alkenyl group, an aryl group or a hydrogen atom, more preferably an alkyl group or a hydrogen atom.

In the general formula (VI-3), B₁ and B₂ independently represent an oxygen atom or a sulfur atom. Both of B₁ and B₂ are preferably the same atom, more preferably a sulfur atom. A₂ represents an alkylene group preferably having 1 to 20 carbon atoms such as a methylene group, an ethylene group, a propylene group, a 1-octylethylene group, etc. or an arylene group preferably having 6 to 20 carbon atoms such as a 1,2-phenylene group, a 4-octyloxy-1,2-phenylene group, etc., preferably an ethylene group, a propylene group or a 1,2-phenylene group optionally having substituents.

In the general formula (VI-4), R₃₄ represents any one of an alkyl group, an alkenyl group, a cycloalkyl group, an aryl group, a heterocyclic group, an alkoxy group and an aryloxy group with preferable examples being the same as those of R₁₉ to R₂₆, or an alkylthio group preferably having 1 to 20 carbon atoms such as a methylthio group, an isopropylthio group, etc. or an arylthio group preferably having 6 to 20 carbon atoms such as a phenylthio group, a 4-methylphenylthio group, etc. R₃₄ is preferably an alkyl group, an aryl group, an alkoxy group or aryloxy group, more preferably an alkoxy group or an aryloxy group, particularly preferably an alkoxy group.

In the general formula (VI-5), R₃₅ and R₃₆ independently represent any one of an alkenyl group, a cycloalkyl group, an aryl group, an alkoxy group and an amino group with preferable examples being the same as those of R₁₉ to R₂₆, or a hydrogen atom, an alkyl group preferably having 1 to 20 carbon atoms such as a methyl group, an ethyl group, a t-butyl group, a chloromethyl group, a trifluoromethyl group, a benzyl group, etc. or a heterocyclic group preferably having 1 to 20 carbon atoms such as a 2-thienyl group, a 3-thienyl group, a 2-pyrrolyl group, a 2-furanyl group, a 4-pyridyl group, a 2-imidazolyl group, etc. R₃₅ and R₃₆ preferably represent an aryl group, an alkyl group or a heterocyclic group, more preferably a phenyl group, a methyl group, a t-butyl group, a trifluoromethyl group or a 2-thienyl group, particularly preferably a methyl group, a t-butyl group or a trifluoromethyl group, respectively. It is most preferable that both R₃₄ and R₃₅ are a methyl group or a t-butyl group, or that R₃₄ is a trifluoromethyl group and R₃₅ is a methyl group.

In the general formula (VI-5), R₃₇ represents any one of an alkyl group, an alkenyl group, an aryl group and a halogen atom with preferable examples being the same as those of R₁₉ to R₂₆, or a hydrogen atom. R₃₇ preferably represents an alkyl group, a halogen atom or a hydrogen atom, more preferably an alkyl group or a hydrogen atom, and particularly preferably a hydrogen atom.

Specific examples X-1 to X-92 of the ligand X₁ will be illustrated below without intention of restricting the scope of the present invention defined by the claims attached hereto. Incidentally, chemical formulae shown below are just a limiting structure of possible resonance structures, and distinction between a covalent bond represented by - and a coordinating bond represented by ··· is also just formal and therefore these bonds do not mean an absolute distinction.

| | | | |
|---|---|---|---|
| X-1 | 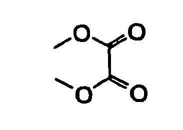 | X-2 | 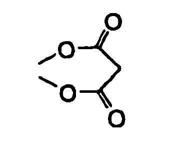 |
| X-3 | 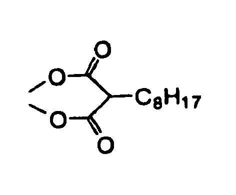 | X-4 | 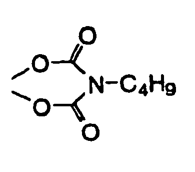 |
| X-5 | 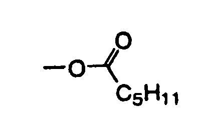 | X-6 | 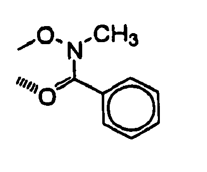 |
| X-7 | 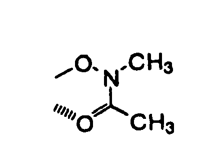 | X-8 | 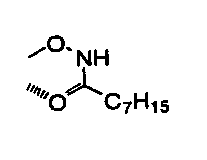 |
| X-9 | 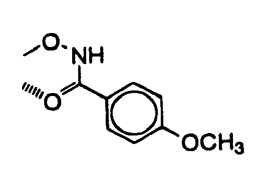 | X-10 | 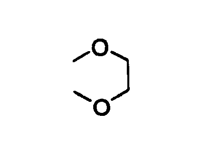 |
| X-11 | 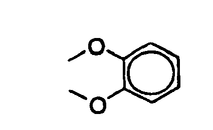 | X-12 | 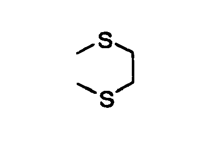 |
| X-13 | 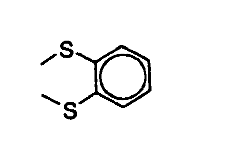 | X-14 | 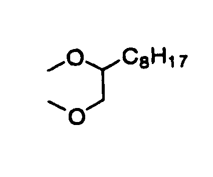 |
| X-15 | 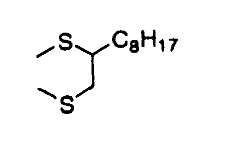 | X-16 | 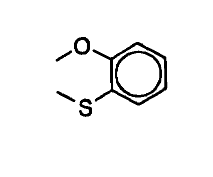 |
| X-17 | 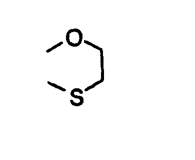 | X-18 | 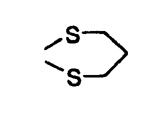 |
| X-19 | 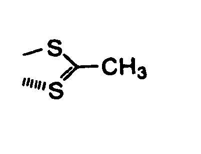 | X-20 | 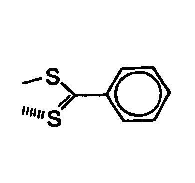 |
| X-21 | 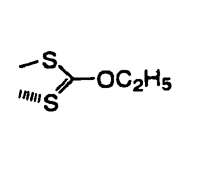 | X-22 | 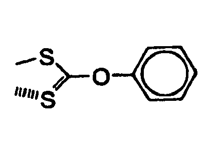 |
| X-23 | 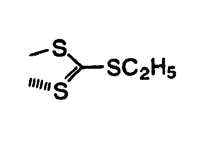 | X-24 | 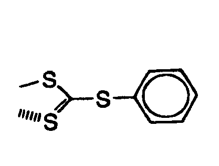 |
| X-25 | 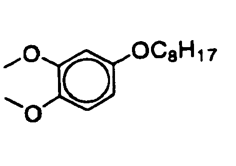 | X-26 | 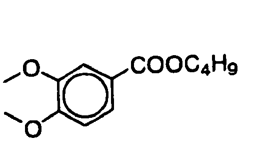 |
| X-27 | 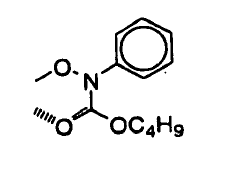 | X-28 | 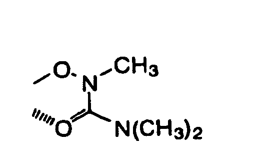 |
| X-29 | 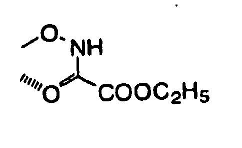 | X-30 | 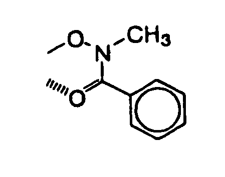 |
| X-31 | 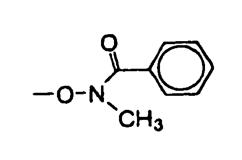 | X-32 | -OCH₃ |
| X-33 | 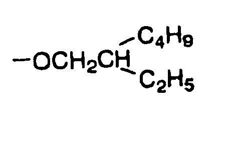 | X-34 | 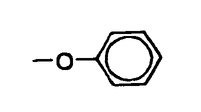 |
| X-35 | -SC₆H₁₃ | X-36 | 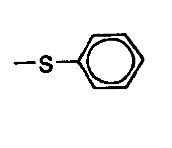 |
| X-37 | 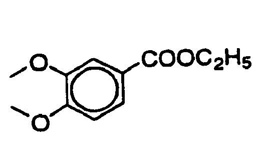 | X-38 | 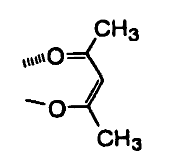 |
| X-39 | 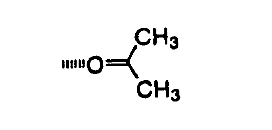 | X.40 | 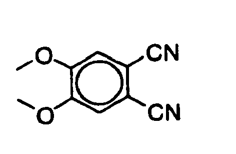 |
| X-41 | 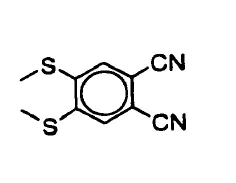 | X-42 | 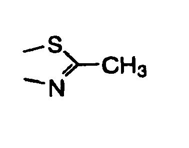 |
| X-43 | 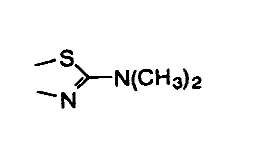 | X-44 | 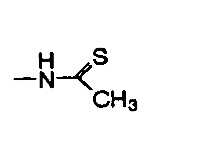 |
| X-45 | 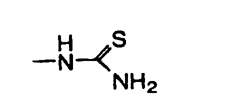 | X.46 | 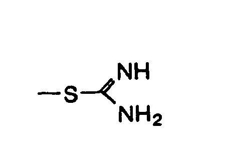 |
| X-47 | 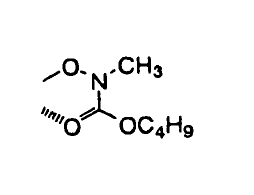 | X-48 | 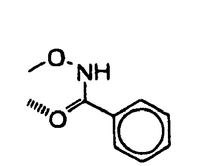 |
| X-49 | 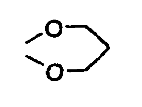 | X-50 | 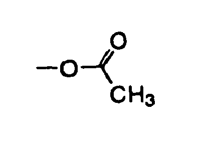 |
| X-51 | 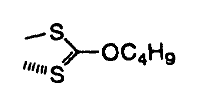 | X-52 | 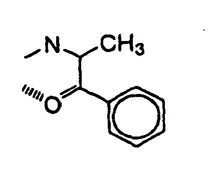 |
| X-53 | 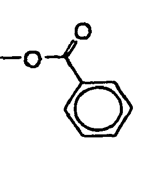 | X-54 | 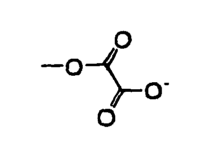 |
| X.55 | -O(CH₂)₂OH | X-56 | 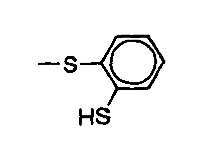 |
| X-57 | 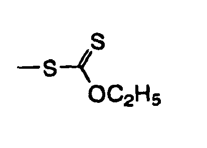 | X-58 | 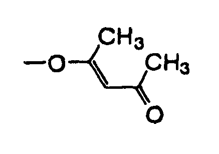 |
| X-59 | 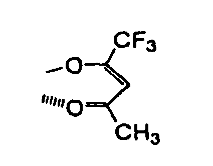 | X-60 | 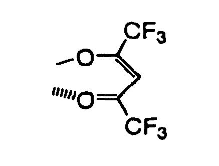 |
| X-61 | 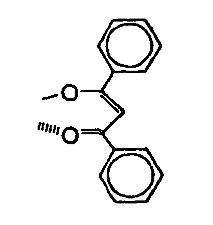 | X-62 | 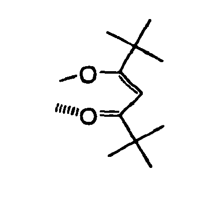 |
| X-63 | 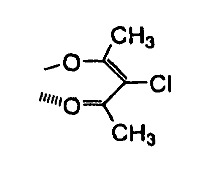 | X-64 | 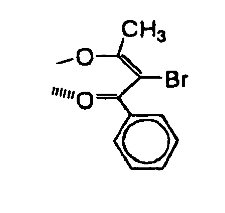 |
| X-65 | 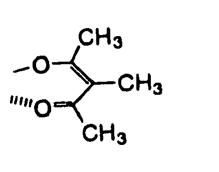 | X-66 | 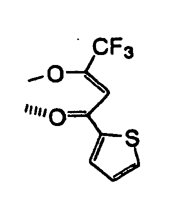 |
| X-67 | 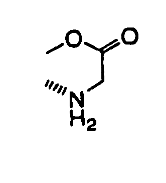 | X-68 | 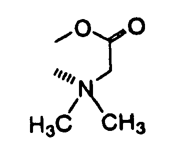 |
| X-69 | 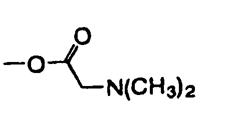 | X-70 | 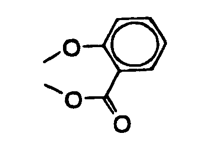 |
| X-71 | 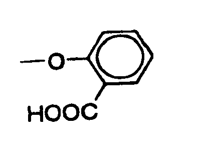 | X-72 | 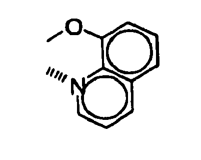 |
| X-73 | 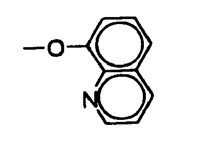 | X-74 | 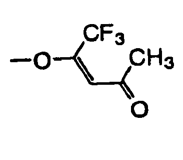 |
| X-75 | 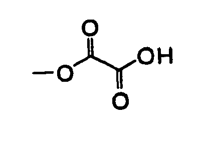 | X-76 | 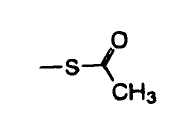 |
| X-77 | 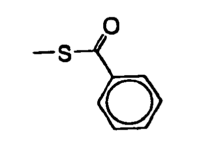 | X-78 | 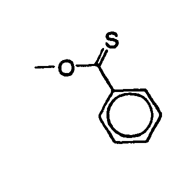 |
| X-79 | 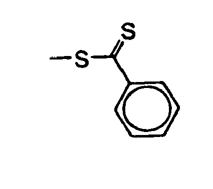 | X-80 | 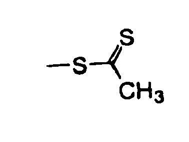 |
| X-81 | 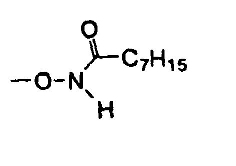 | X-82 | 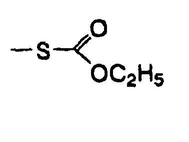 |
| X-83 | 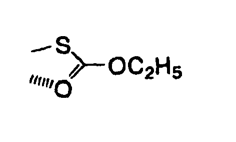 | X-84 | 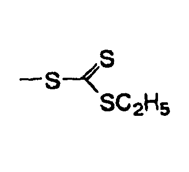 |
| X-85 | 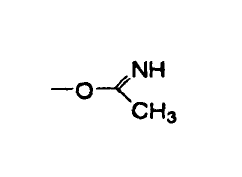 | X-86 | 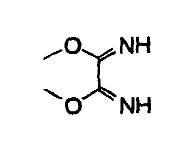 |
| X-87 | -SCH₃ | X-88 | -S(CH₂)₂SH |
| X-89 | -S(CH₂)₃SH | X-90 | 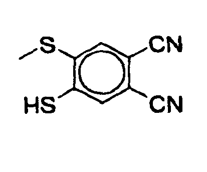 |
| X-91 | -O(CH₂)₃OH | X-92 | 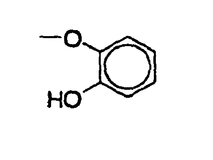 |

### (4) Counter ion CI₁

CI₁ represents a counter ion optionally contained in the metal complex dye to neutralize charge thereof. Whether the metal complex dye is a cation or an anion and whether the dye has the net ionic charge or not depends on a metal atom, ligands and substituents therein. When a substituent has a dissociative group, it may dissociate the group to have charge. In this case, the charge of the whole complex is also neutralized by the CI₁.

Typical positive counter ions are inorganic or organic ammonium ions such as a tetraalkyl ammonium ion, a pyridinium ion, etc., proton and alkali metal ions. On the other hand, negative counter ions may be inorganic or organic, and examples thereof include a halide ion such as a fluoride ion, a chloride ion, a bromide ion, an iodide ion, etc., a substituted aryl sulfonate ion such as a p-toluene sulfonate ion, a p-chlorobenzene sulfonate ion, etc., an aryl disulfonate ion such as a 1,3-benzene disulfonate ion, a 1,5-naphthalene disulfonate ion, a 2,6-naphthalene disulfonate ion, etc., an alkyl sulfate ion such as a methyl sulfate ion, etc., a sulfate ion, a thiocyanate ion, a perchlorate ion, a tetrafluoroborate ion, a hexafluorophosphate ion, a picrate ion, an acetate ion, a trifluoromethane sulfonate ion, etc. Further, ionic polymers or other dyes having an opposite charge to the dye may be also used as a charge-balancing counter ion. Alternatively metal complex such as bisbenzene-1,2-dithiolato nickel (III), etc. can be also used in the present invention.

### (5) Interlocking group

The dye represented by the general formula (11) has preferably at least one, more preferably 2 or more interlocking group suitable for the surface of semiconductor particles. Preferable interlocking groups are acidic groups having a dissociative proton such as a carboxyl group (-COOH), a sulfonic acid group (-S0₃H), a hydroxyl group (-OH), a phsphonyl group (-P(O)(OH)₂, etc.), a phosphoryl group (-OP(O)(OH)₂, etc.), a hydroxamic acid group (-CONHOH, etc.), etc.

### (6)

### Ligand LL₃

LL₃ represents a bidentate ligand represented by the following general formula (IV). 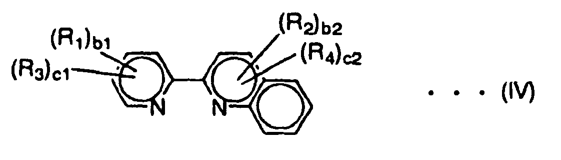 m4 indicating the number of LL3 represents an integer of 1 to 3, preferably 1 or 2, more preferably 2. When m4 is 2 or 3, LL₃'s may be the same or different ligands.

In the general formula (IV), R₁ and R₂ independently represent a carboxyl group, a sulfonic acid group, a hydroxyl group, a hydroxamic acid group preferably having 1 to 20 carbon atoms such as -CONHOH, - CONCH₃OH, etc., a phosphoryl group such as -OP(O)(OH)₂, etc., or a phosphonyl group such as -P(O)(OH)₂, etc. Of these groups, preferred are a carboxyl group, a phosphoryl group and a phosphonyl group, more preferably a carboxyl group and a phosphonyl group, and most preferably a carboxyl group.

In the general formula (IV), R₃ and R₄ independently represent a substituent. Preferred examples thereof include an alkyl group, an alkenyl group, a cycloalkyl group, an aryl group, a heterocyclic group, an alkoxy group, an aryloxy group, an acyloxy group, an alkoxycarbonyl group, a carbamoyl group, an acylamino group, an amino group, an acyl group, a sulfonamido group and a halogen atom with preferable examples being the same as those of R₁₉ to R₂₆, and a cyano group, a hydroxyl group and an alkynyl group preferably having 2 to 20 of carbon atoms such as an ethynyl group, a butadiynyl group, a phenylethynyl group, etc.

R₃ and R₄ is more preferably an alkyl group, an alkenyl group, a cycloalkyl group, an alkoxy group, an aryloxy group, an acylamino group, an amino group, a hydroxyl group or an alkynyl group, particularly preferably an alkyl group, an alkenyl group, an alkoxy group, an acylamino group or an amino group, most preferably an alkyl group, an alkoxy group or an amino group, independently.

When LL₃ contains an alkyl group, an alkenyl group, etc., they may be a substituted or unsubstituted group having a straight or branched structure. When LL₃ contains an aryl group, a heterocyclic group, etc., they may be a substituted or unsubstituted group that may have a monocyclic or condensed ring structure.

In the general formula (IV), b1 and b2 independently represent an integer of 0 to 4. R₁'s may be the same or different groups when b1 is 2 or more, and R₂'s may be the same or different groups when b2 is 2 or more. R₁ may be bonded to any carbon atom in the pyridine ring, and R₂ may be bonded to any carbon atom in the quinoline ring. b1 is preferably an integer of 0 to 2, more preferably 0 or 1. b2 is preferably 1 or 2. The sum of b1 and b2 is preferably 1 to 4, more preferably 1 or 2.

In the general formula (IV), c1 represents an integer of 0 to 3, and c2 represents an integer of 0 to 5. R₃'s may be the same or different groups that may be bonded together to form a ring when c1 is 2 or more. R₄'s may be the same or different groups that may be bonded together to form a ring when c2 is 2 or more. R₃ and R₄ may be bonded together to form a ring when both of c1 and c2 are 1 or more. This ring formed by R₃ and R₄ is preferably a benzene ring, a cyclohexane ring or cyclopentane ring. R₃ may be bonded to any carbon atom in the pyridine ring, and R₄ may be bonded to any carbon atom in the quinoline ring.

c1 preferably represents an integer of 0 to 2, more preferably represents 0 or 1. c2 preferably represents an integer of 1 to 4, more preferably represents 1 or 2. The sum of c1 and c2 is preferably 1 to 6, more preferably 1 to 3.

As the specific examples of LL₃, L-20 to L-22 shown above, P-1 to P-47 illustrated below, etc. may be given. The scope of the present invention defined by the claims attached hereto is not restricted by the examples.

| | | | |
|---|---|---|---|
| P-1 | 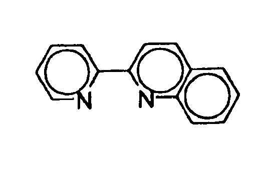 | P-2 | 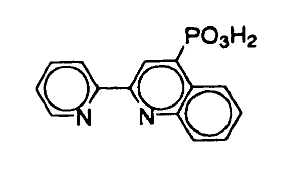 |
| P-3 | 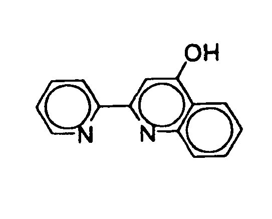 | P-4 | 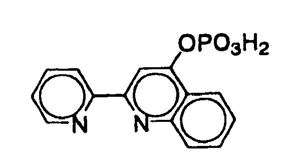 |
| P-5 | 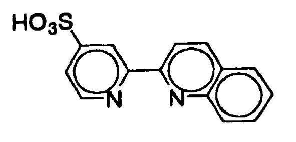 | P-6 | 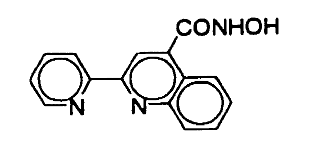 |
| P-7 | 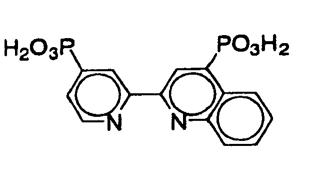 | P-8 | 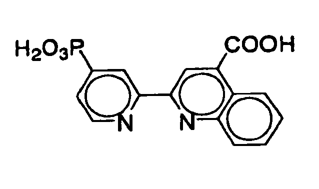 |
| P-9 | 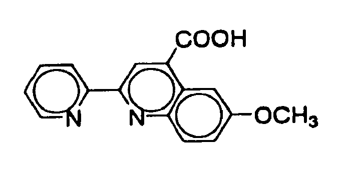 | P-10 | 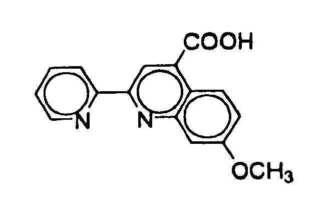 |
| P-11 | 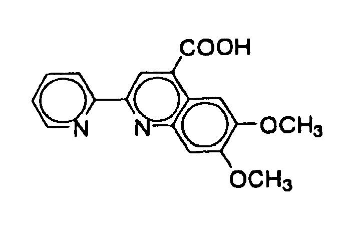 | P-12 | 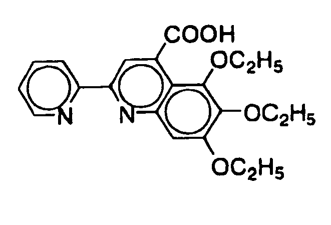 |
| P-13 | 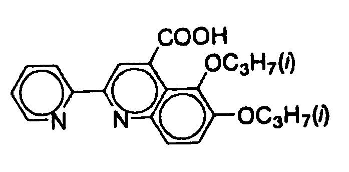 | P-14 | 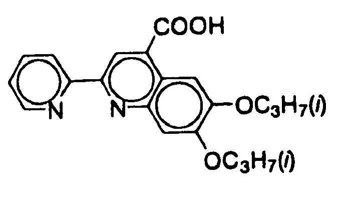 |
| P-15 | 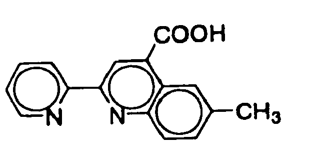 | P-16 | 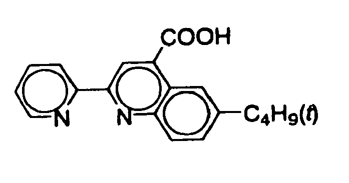 |
| P-17 | 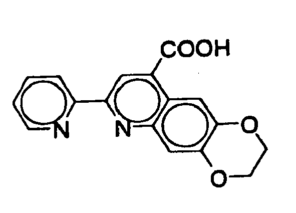 | P-18 | 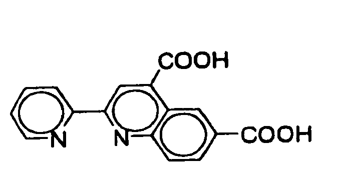 |
| P-19 | 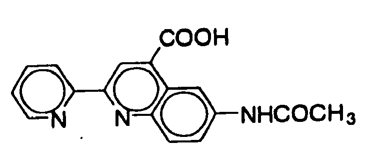 | P-20 | 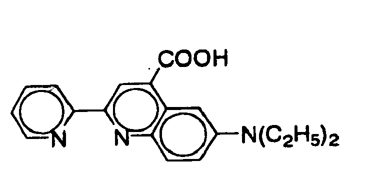 |
| P-21 | 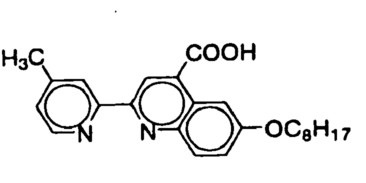 | P-22 | 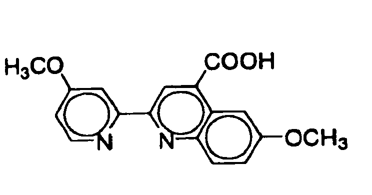 |
| P-23 | 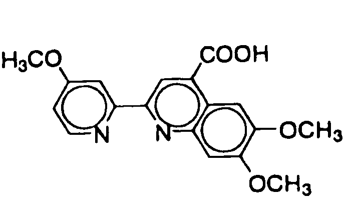 | P-24 | 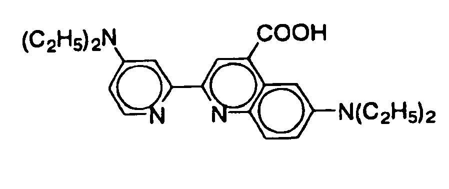 |
| P-25 | 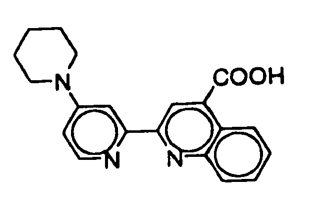 | P-26 | 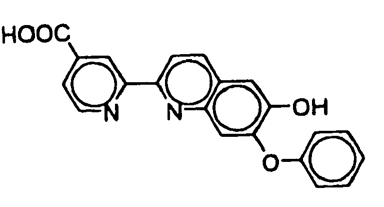 |
| P-27 | 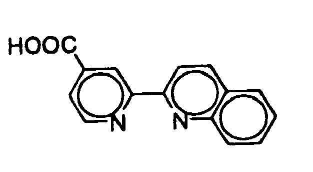 | P-28 | 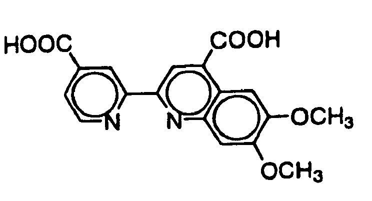 |
| P-29 | 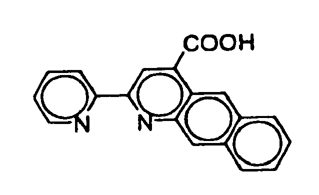 | P-30 | 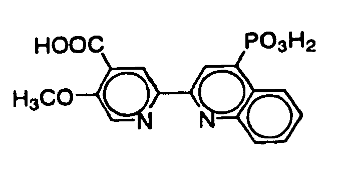 |
| P-31 | 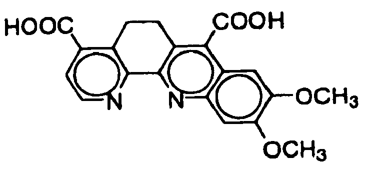 | P-32 | 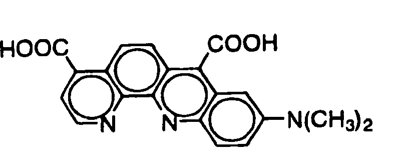 |
| P-33 | 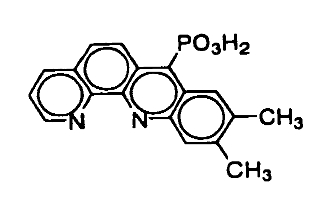 | P-34 | 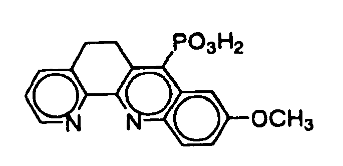 |
| P-35 | 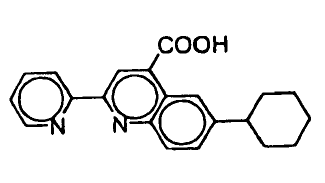 | P-36 | 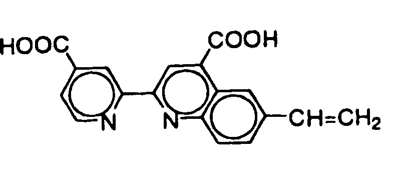 |
| P-37 | 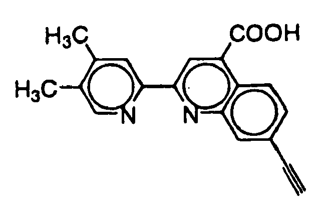 | P-38 | 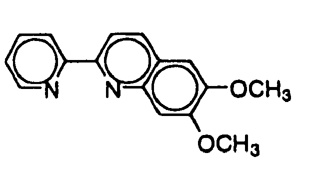 |
| P-39 | 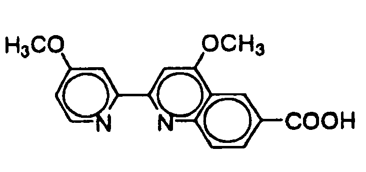 | P-40 | 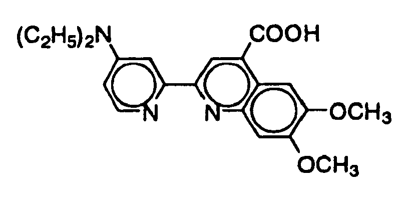 |
| P-41 | 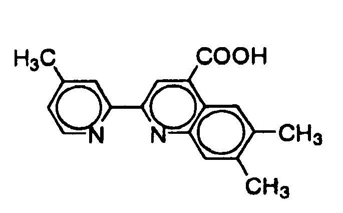 | P-42 | 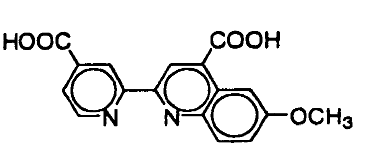 |
| P-43 | 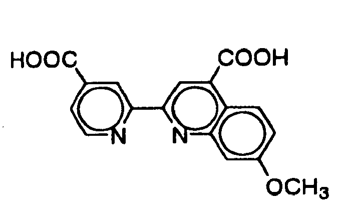 | P-44 | 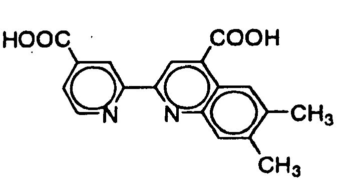 |
| P-45 | 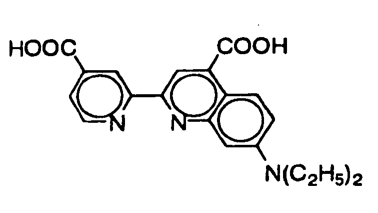 | P-46 | 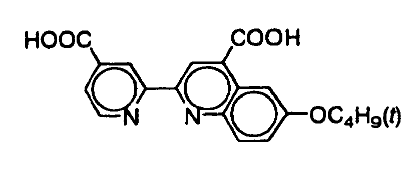 |
| P-47 | 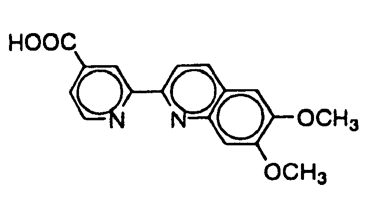 | | |

### (4) Ligand X₂

In the general formula (II), X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group and an aryloxy group with preferable examples being the same as those of X₁, and a thiocarbamate group preferably having 1 to 20 carbon atoms such as an N,N-diethylthiocarbamate group, etc., a dithiocarbamate group preferably having 1 to 20 carbon atoms such as an N-phenyldithiocarbamate group, an N,N-dimethyldithiocarbamate group, an N,N-diethyldithiocarbamate group, an N,N-dibenzyldithiocarbamate group, etc., an acyl group preferably having 1 to 20 carbon atoms such as an acetyl group, a benzoyl group, etc., a thiocyanate group, an isothiocyanate group, a cyanate group, an isocyanate group and a cyano group, or a monodentate or bidentate ligands selected from the group consisting of ketones, carbonamides, thiocarbonamides, thioureas and isothioureas with preferable examples being the same as those of X₁, and halogen atoms such as a chlorine atom, a bromine atom, an iodine atom, etc. and carbonyl.

m5 indicating the number of X₂ represents an integer of 0 to 3. X₂'s may be the same or different ligands that may be bonded together when m5 is 2 or 3. m5 is preferably 0 to 2, more preferably 1 or 2. It is particularly preferable that m5 is 2 when X₂ is a monodentate ligand, and that m5 is 1 when X₂ is a bidentate ligand.

In the case where M₂ is a metal atom tend to form four-coordinated complex such as Cu, Pd, Pt, etc., it is preferred that m3 is 0 and m4 is 1 or 2. In this case, m5 is preferably 1 or 2 when m4 is 1, and m5 is preferably 0 when m4 is 2.

In the case where M₂ is a metal atom tend to form six-coordinated complex, m4 is preferably 1 or 2, more preferably 2. In this case, m3 is preferably 1 or 2, more preferably 1 when m4 is 1, m5 is preferably 1 or 2 when m3 is 1, and m5 is preferably 0 when m3 is 2. On the other hand, m3 is preferably 0 or 1, more preferably 0 when m4 is 2, m5 is preferably 1 or 2 when m3 is 0, and m5 is preferably 0 when m3 is 1. Further, when m4 is 3, both of m3 and m5 are preferably 0.

Preferred bidentate ligand X₂ is a ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group and an acyl group, or a ligand selected from the group consisting of 1,3-diketones, carbonamides, thiocarbonamides and thioureas. Preferred monodentate ligand X₂ is a ligand which coordinates to M₂ via one or two groups selected from the group consisting of an alkylthio group, an arylthio group, a thiocyanate group, an isothiocyanate group, a cyanate group, an isocyanate group and a cyano group, or a ligand selected from a member consisting of 1,3-diketones, carbonamides, thiocarbonamides, thioureas, halogen atoms and carbonyl.

X₂ is more preferably a ligand which coordinates to M₂ via one or two groups selected from the group consisting of an acyloxy group, an acylaminooxy group, a thioacylthio group, a dithiocarbonate group, a trithiocarbonate group, an alkylthio group, an arylthio group, an alkoxy group, an aryloxy group, a dithiocarbamate group, a thiocyanate group, an isothiocyanate group, a cyanate group, an isocyanate group and a cyano group, or a ligand selected from the group consisting of 1,3-diketones, thioureas, halogen atoms and carbonyl, furthermore preferably a ligand which coordinates to M₂ via one or two groups selected from the group consisting of an acyloxy group, an acylaminooxy group, an arylthio group, a dithiocarbamate group, a thiocyanate group, an isothiocyanate group, a cyanate group, an isocyanate group and a cyano group, or a ligand selected from the group consisting of 1,3-diketones, thioureas and halogen atoms, particularly preferably a ligand which coordinates to M₂ via one or two groups selected from the group consisting of a dithiocarbamate group, a thiocyanate group, an isothiocyanate group, a cyanate group and an isocyanate group, or a 1,3-diketone or a halogen atom, most preferably a ligand which coordinates to M₂ via a dithiocarbamate group, a thiocyanate group and/or an isothiocyanate group, or a 1,3-diketone.

When X₂ contains an alkyl group, an alkenyl group, an alkynyl group, an alkylene group, etc., they may be a substituted or unsubstituted group having a straight or branched structure. When X₂ contains an aryl group, a heterocyclic group, a cycloalkyl group, etc., they may be a substituted or unsubstituted group having a monocyclic or condensed ring structure.

As the specific examples of X₂, X-1 to X-92 shown above, and X-93 to X-111 illustrated below may be given. The scope of the present invention defined by the claims attached hereto is not restricted by the examples. Incidentally, chemical formulae shown below are just a limiting structure of possible resonance structures, and distinction between a covalent bond represented by - and a coordinating bond represented by ··· is also just formal and therefore these bonds do not mean an absolute distinction.

| | | | |
|---|---|---|---|
| X-93 | 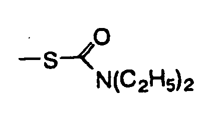 | X-94 | 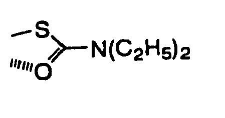 |
| X-95 | 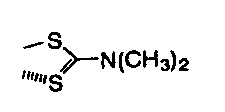 | X-96 | 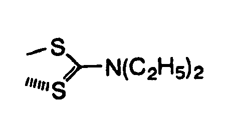 |
| X-97 | 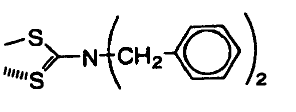 | X-98 | 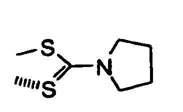 |
| X-99 | 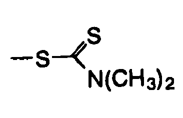 | X-100 | 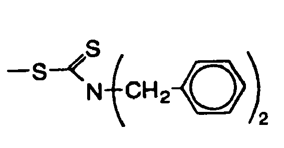 |
| X-101 | 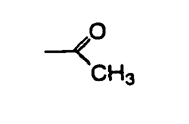 | X-102 | 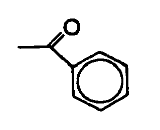 |
| X-103 | '''''' CO | X-104 | -NCS |
| X-105 | -SCN | X-106 | -NCO |
| X-107 | -OCN | X-108 | -Cl |
| X-109 | -Br | X-110 | -I |
| X-111 | -CN | | |

### (5) Counter ion Cl₂

CI₂ represents a counter ion optionally contained in the metal complex dye to neutralize charge thereof, being the same as CI₁, above mentioned. Examples and preferable embodiments of CI₂ are equal to those of CI₁.

### Interlocking group

The dye represented by the general formula (II) has preferably at least one interlocking group suitable for the surface of semiconductor particles. The number of the interlocking group in the dye represented by the general formula (II) is more preferably one to six, particularly preferably one to four.

In particular, it is preferable that LL₃ has at least one interlocking group, and it is more preferable that LL₂ and LL₃ have at least one interlocking group, respectively.

### (7) Specific examples of the metal complex dye

As for the second metal complex dye according to a particularly preferable embodiment of the present invention, in the general formula (II), M₂ is Ru, LL₂ is a bidentate or tridentate ligand represented by any one of the general formulae (V-1) to (V-8), LL₃ is a bidentate ligand represented by the general formula (IV), X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group, an acyl group, a thiocyanate group, an isothiocyanate group, a cyanate group, an isocyanate group and a cyano group, or a monodentate or bidentate ligand selected from the group consisting of ketones, carbonamides, thiocarbonamides, thioureas, isothioureas, halogen atoms and carbonyl, m3 is 0 or 1, m4 is 1 or 2, LL₃'s may be the same or different ligands when m4 is 2, m5 represents an integer of 0 to 2, X₂'s may be the same or different ligands that may be bonded together when m5 is 2, at least one of m3 and m5 is not 0, and CI₂ represents a counter ion optionally contained to neutralize charge of the metal complex dye.

As specific examples of the second dye represented by the general formula (II), above-mentioned D-16 to D-19, D-23, D-24, D-39, D-57 to D-61, D-65, D-67, D-71 to D-82, etc. may be given. Further specific examples D-93 to D-155 thereof will be illustrated below without intention of restricting the scope of the present invention defined by the claims attached hereto.

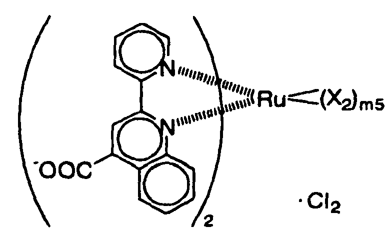

| | (X₂)m₅ | Cl₂ |
|---|---|---|
| D-93 | (X-104)₂ | (H⁺)₂ |
| D-94 | (X-104)₂ | (N⁺ⁿBu₄)₂ |
| D-95 | X-96 | H⁺ |
| D-96 | (X-105)₂ | (H⁺)₂ |
| D-97 | (X-106)₂ | (H⁺)₂ |
| D-98 | (X-108)₂ | (H⁺)₂ |
| D-99 | (X-111)₂ | (H⁺)₂ |

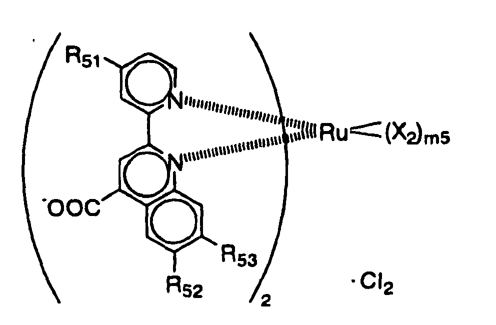

| | R₅₁ | R₅₂ | R₅₃ | (X₂)ₘ₅ | Cl₂ |
|---|---|---|---|---|---|
| D-100 | H | -OCH₃ | H | (X-104)₂ | (H⁺)₂ |
| D-101 | H | -OCH3 | H | X-38 | H⁺ |
| D-102 | H | -OCH₃ | H | X-70 | (H⁺)₂ |
| D-103 | H | -OCH₃ | -OCH₃ | (X-104)₂ | (H⁺)₂ |
| D-104 | H | -OCH₃ | -OCH₃ | X-59 | H⁺ |
| D-105 | H | -N(C₂H₅)₂ | H | (X-104)₂ | (H⁺)₂ |
| D-106 | H | -C₄H₉(*t*) | H | (X-104)₂ | (H⁺)₂ |
| D-107 | H | H | -N(C₂H₅)₂ | X-72 | H⁺ |
| D-108 | -CH₃ | -CH₃ | -CH₃ | (X-104)₂ | (H⁺)₂ |
| D-109 | -OCH₃ | -OCH₃ | -OCH₃ | (X-104)₂ | (H⁺)₂ |
| D-110 | -N(C₂H₅)₂ | -N(C₂H₅)₂ | H | (X-104)₂ | (H⁺)₂ |
| D-111 | H | -NHCOCH₃ | H | (X-104)₂ | (H⁺)₂ |

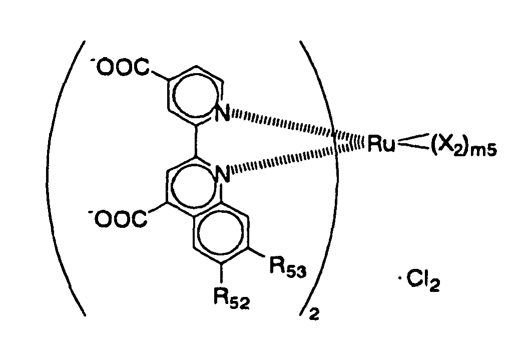

| | R₅₂ | R₅₃ | (X₂)m₅ | Cl₂ |
|---|---|---|---|---|
| D-112 | H | H | (X-104)₂ | (H⁺)₂ |
| D-113 | H | H | X-96 | H⁺ |
| D-114 | -OCH₃ | -OCH₃ | (X-104)₂ | (H⁺)₂ |
| D-115 | -OCH₃ | -OCH₃ | X-38 | H⁺ |
| D-116 | -OCH₃ | H | X-70 | (H⁺)₂ |
| D-117 | -CH₃ | -CH₃ | (X-104)₂ | (H⁺)₂ |
| D-118 | -CH=CH₂ | H | (X-104)₂ | (H⁺)₂ |
| D-119 | -N(C₂H₅)₂ | H | (X-104)₂ | (H⁺)2 |
| D-120 | -N(C₂H₅)₂ | H | X-96 | H⁺ |

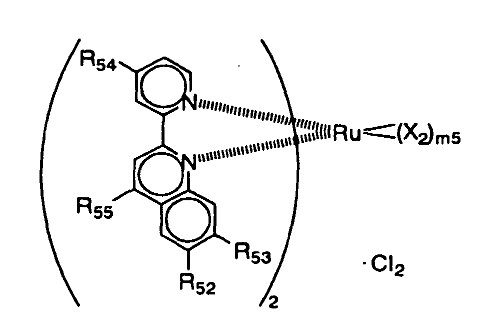

| | R₅₂ | R₅₃ | R₅₄ | R₅₅ | (X₂)m₅ | Cl₂ |
|---|---|---|---|---|---|---|
| D-121 | H | H | H | -PO₃H₂ | (X-104)₂ | - |
| D-122 | H | H | -SO₃H | H | (X-104)₂ | - |
| D-123 | H | H | -PO₃H₂ | -PO₃H₂ | (X-104)₂ | - |

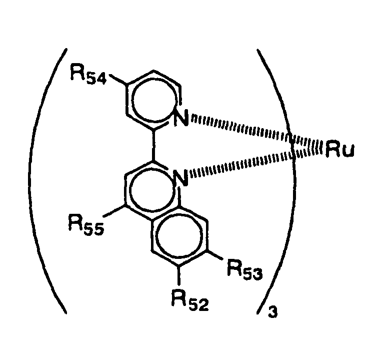

| | R₅₂ | R₅₃ | R₅₄ | R₅₅ |
|---|---|---|---|---|
| D-124 | H | H | H | -COOH + -COO⁻ |
| D-125 | H | H | H | -PO₃H₂ + -PO₃H⁻ |
| D-126 | -OCH₃ | H | H | -COOH + -COO⁻ |
| D-127 | -N(C₂H₅)₂ | -N(C₂H₅)₂ | H | -COOH + -COO⁻ |
| D-128 | -COOH | H | H | -COOH + -COO⁻ |
| D-129 | -COOH | -N(C₂H₅)₂ | H | -COOH + -COO⁻ |

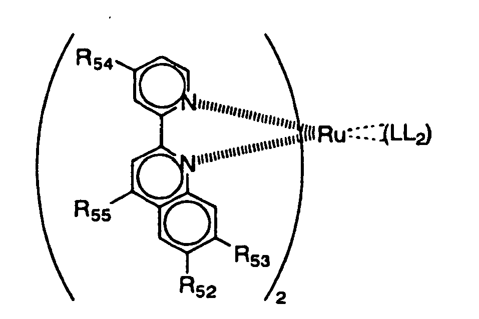

| | R₅₂ | R₅₃ | R₅₄ | R₅₅ | LL₂ |
|---|---|---|---|---|---|
| D-130 | H | H | H | -COO⁻ | L-5 |
| D-131 | H | H | H | -COO⁻ | L-10 |
| D-132 | -OCH₃ | -OCH₃ | H | -COO⁻ | L-5 |
| D-133 | -N(C₂H₅)₂ | H | H | -COO⁻ | L-5 |
| D-134 | -OCH₃ | -OCH₃ | H | -COO⁻ | L-24 |
| D-135 | -OCH₃ | -OCH₃ | -COOH | -COO⁻ | L-72 |

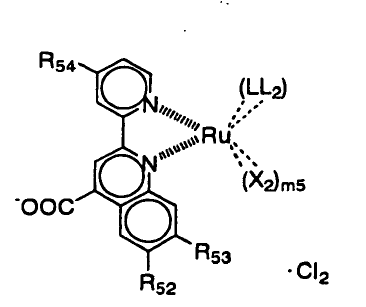

| | R₅₂ | R₅₃ | R₅₄ | LL₂ | (X₂)ₘ₅ | Cl₂ |
|---|---|---|---|---|---|---|
| D-136 | H | H | H | L-5 | (X-104)₂ | (H⁺)₂ |
| D-137 | H | H | H | L-5 | X-96 | H⁺ |
| D-138 | -OCH₃ | H | H | L-5 | (X-104)₂ | (H⁺)₂ |
| D-139 | -OCH₃ | -OCH₃ | H | L-5 | (X-104)₂ | (H⁺)₂ |
| D-140 | -N(C₂H₅)₂ | H | H | L-5 | (X-104)₂ | (H⁺)₂ |
| D-141 | -OCH₃ | -OCH₃ | H | L-88 | (X-104)₂ | (H⁺)₂ |

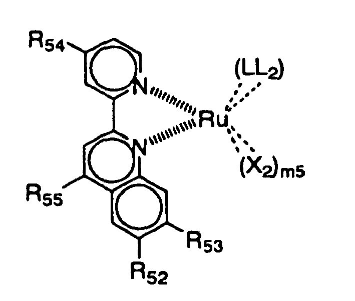

| | R₅₂ | R₅₃ | R₅₄ | R₅₅ | LL₂ | (X₂)ₘ₅ |
|---|---|---|---|---|---|---|
| D-142 | H | H | -COOH | -COO⁻ | L-5 | (X-104)₂ |
| D-143 | -COOH | H | H | -COO⁻ | L-5 | (X-104)₂ |
| D-144 | H | H | -COO⁻ | H | L-5 | (X-104)₂ |
| D-145 | -OCH₃ | -OCH₃ | -COOH | -COO⁻ | L-42 | (X-104)₂ |
| D-146 | -OCH₃ | -OCH₃ | -COOH | -COO⁻ | L-88 | (X-104)₂ |

| | |
|---|---|
| D-147 | 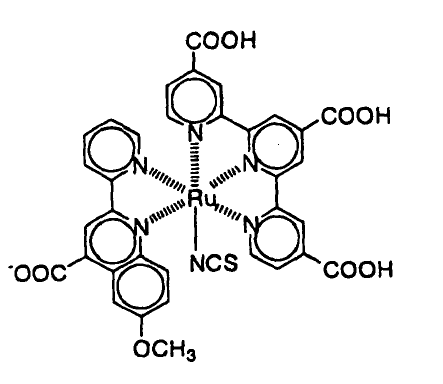 |
| D-148 | 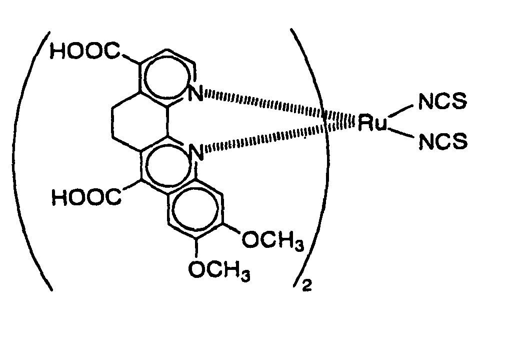 |
| D-149 | 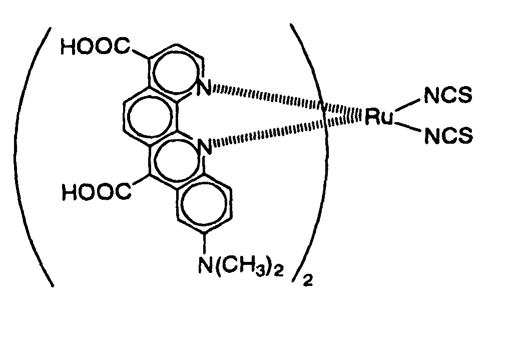 |
| D-150 | 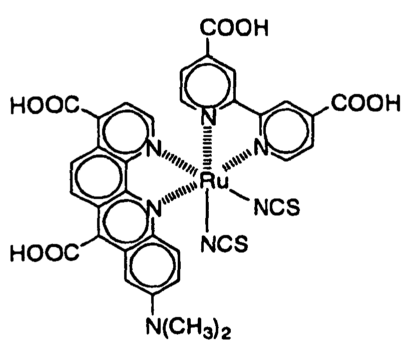 |

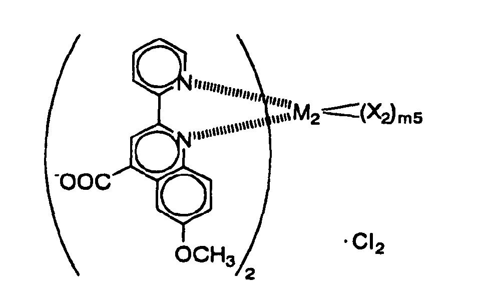

| | M₂ | (X₂)ₘ₅ | Cl₂ |
|---|---|---|---|
| D-151 | Fe | (X-104)₂ | (H⁺)₂ |
| D-152 | OS | (X-104)₂ | (H⁺)₂ |
| D-153 | Cu | - | H⁺ |

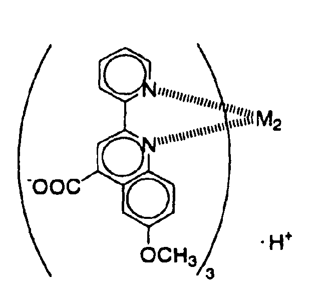

| | M₂ |
|---|---|
| D-154 | Fe |
| D-155 | Os |

Synthesis of the metal complex dye represented by the general formula (II) according to the present invention can be carried out based on methods described in literatures such as Chem. Phys. Lett., 85, 309 (1982), Chem. Phys. Lett., 71, 220 (1980), J. Am. Chem. Soc., 115, 6382 (1993) and references therein, etc. Ligands composing the dye can be synthesized referring to Synth. Commun., 27, 2165 (1997), Aust. J. Chem., 25, 1631 (1972), etc.

### EXAMPLES

The present invention will be explained in more detail with reference to examples below. The present invention is not restricted by these examples.

### EXAMPLE 1

A first metal complex dye, photoelectric conversion device and photo-electrochemical cell not forming part of the invention

### 1. Synthesis of metal complex dye

Specific methods for synthesizing the first metal complex dyes of the present invention will be explained below.

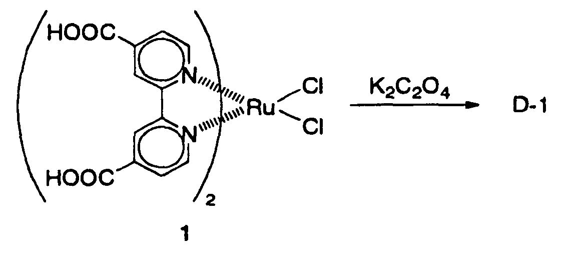

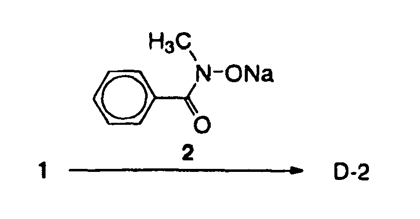

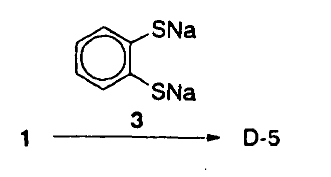

### (A) Synthesis of D-1

In a mixed solvent composed of 10 ml of ethanol and 10 ml of water were dissolved 0.66 g (1 mmol) of complex 1 synthesized by a method described in J. Am. Chem. Soc., 115, 6382 (1993) and 1.68 g (10 mmol) of potassium oxalate. The resultant solution was refluxed for 6 hours under nitrogen, and then cooled. To this was added triethylamine to adjust the pH value thereof to 10, and concentrated. Residue was purified by column chromatography using Sephadex column LH-20 (developing solvent: methanol) to obtain 0.36 g of the metal complex dye D-1 (crystal, 50% yield). The structure of the product was identified by NMR spectra and MS spectra.

### (B) Synthesis of D-2

The metal complex dye D-2 was synthesized in the same manner as synthesis of D-1 except for using sodium hydroxainate **2** in place of potassium oxalate in the same molar amount. The structure of the product was identified by NMR spectra and MS spectra.

### (C) Synthesis of D-5

The metal complex dye D-5 was synthesized in the same manner as synthesis of D-1 except for using sodium 1,2-phenylenesulfide 3 in place of potassium oxalate in the same molar amount. The structure of the product was identified by NMR spectra and MS spectra.

### (D) Syntheses of other dyes

The first metal complex dyes of the present invention other than the above-described dyes can be also easily synthesized by using suitable ligands in a similar method to above.

### 2. Evaluation of thermal stability of dye in solution

3-methoxypropionitrile solutions each comprising 1×10⁻⁴ mol/l of the first metal complex dye D-1, D-2, D-5, D-46 or D-47, or a comparative dye 1 illustrated below were prepared. The thermal stability of each dye was evaluated by a retention (%) of maximum absorbance in the solutions after leaving the solution for 100 hours at 80°C. The results are shown in Table 1.

**Table 1**

| | Retention of Maximum Absorbance (%) |
|---|---|
| D-1 | 98 |
| D-2 | 97 |
| D-5 | 93 |
| D-46 | 98 |
| D-47 | 98 |
| Comparative Dye 1 | 77 |

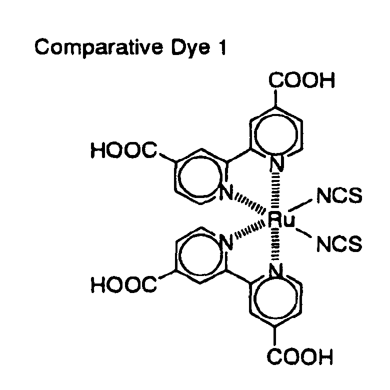

As shown in Table 1, while the comparative dye 1 exhibited significant reduction of the maximum absorbance by de-sulfurized decomposition, each metal complex dyes of the present invention exhibited an excellent thermal stability with little reduction of the maximum absorbance.

### 3. Preparation of titanium dioxide dispersion

A stainless steel vessel coated with Teflon inside and having an inner volume of 200 ml was charged with 15 g of titanium dioxide Degussa P-25 manufactured by Nippon Aerosil K.K., 45 g of water, 1 g of a dispersant Triton X-100 manufactured by Aldrich, and 30 g of zirconia beads having a diameter of 0.5 mm manufactured by Nikkato K.K. These contents were subjected to a dispersion treatment at 1500 rpm for 2 hours by means of a sand-grinder mill manufactured by Imex K.K. The zirconia beads were removed from the resulting dispersion by filtration to obtain the titanium dioxide dispersion. The average particle diameter of the titanium dioxide particles in the dispersion was 2.5 µm. Incidentally, the particle diameter was measured by Master Sizer manufactured by MALVERN.

### 4. Preparation of dye-adsorbed TiO₂ electrode

The above-described dispersion was coated on an electrically conductive surface of a conductive glass having a fluorine-doped tin oxide layer thereon by a glass bar. Used as the conductive glass was 20 mm × 20 mm of TCO Glass-U manufactured by Asahi Glass K.K. with surface resistance of approximately 30 Ω/square. A coating amount of the semiconductor particles was 20 g/m². Herein, on the eight glasses were coated the dispersion at once after adhesive tape was attached to a part of the conductive surface (3 mm from the edge) of each conductive glass as a spacer, and the glasses were arranged so that the adhesive tapes come to both edges thereof. The coated glasses were air-dried for one day at a room temperature after peeling the adhesive tapes. Next, the glasses were placed in an electric furnace (muffle furnace FP-32, manufactured by Yamato Science K.K.), followed by calcinating at 450 °C for 30 minutes to obtain TiO₂ electrodes. After the electrodes were taken out of the furnace and cooled, they were immersed in the methanol solutions each comprising the metal complex dye of the present invention or the comparative dye 1 for 15 hours to absorbing the dyes. The concentration of the dye in the methanol solution was 3 × 10⁻⁴ mol/l. The dye-adsorbed TiO₂ electrodes were further immersed in 4-t-butylpyridine for 15 minutes, then washed with ethanol and air-dried. The thickness of thus-obtained photosensitive layer was 10 µm.

### 5. Preparation of photo-electrochemical cell

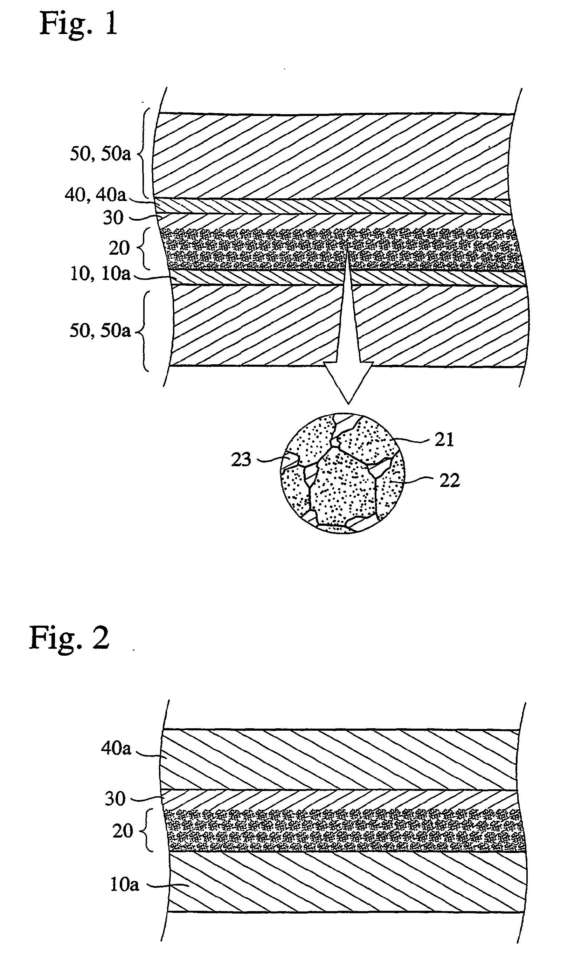

The 20 mm × 20 mm of dye-sensitized TiO₂ electrode glass substrate prepared as described above was put on platinum-vapor deposited glass having the same size as the TiO₂ electrode. Next, an electrolysis solution composed of 3-methoxypropionitrile, and 0.65 mol/l of 1-methyl-3-hexylimidazolium iodide and 0.05 mol/l of iodine as an electrolyte was permeated into a crevice between the glasses through capillarity to be introduced into the TiO₂ electrode, thereby obtaining a photo-electrochemical cell. According to this example, the photo-electrochemical cell as shown in Fig. 1 was manufactured, where the conductive support of the electrically conductive glass comprising the transparent substrate 50a of glass and the electrically conductive layer 10a applied thereon, the photosensitive layer 20 of the dye-sensitized TiO₂, the charge transfer layer 30 of the above-described electrolysis solution, the counter electrically conductive layer 40 of platinum, and the transparent substrate 50a of glass were laminated in this order, and sealed with an epoxy-based sealant.

### 6. Measurement of photoelectric conversion efficiency, and stability to heat and light

A simulated sunlight was irradiated to the photo-electrochemical cell, and the electricity generated in the cell was measured by current-voltage tester Keithley SMU238. The simulated sunlight was obtained by passing light of a 500 W xenone lamp manufactured by Ushio K.K. through an AM 1.5 filter manufactured by Oriel Co. and a sharp cut filter Kenko L-42. The simulated sunlight was free of an ultraviolet radiation and had intensity of 86 mW/cm². This measurement was carried out with respect to the photo-electrochemical cell each comprising the metal complex dyes shown in Table 2. The photoelectric conversion efficiency (η) of each cell is also shown in Table 2. Further, retention (%) of the photoelectric conversion efficiency after a continuous irradiation of the simulated sunlight for 720 hours at 80 °C is also shown in Table 2.

**Table 2**

| Metal Complex Dye | Photoelectric Conversion Efficiency (%) | Retention of Photoelectric Conversion Efficiency (%) |
|---|---|---|
| D-1 | 5.6 | 95 |
| D-2 | 5.5 | 95 |
| D-7 | 4.2 | 90 |
| 0-16 | 6.1 | 95 |
| D-17 | 6.0 | 94 |
| D-20 | 5.7 | 96 |
| D-22 | 4.8 | 92 |
| D-25 | 5.8 | 95 |
| D-30 | 5.9 | 95 |
| D-34 | 6.0 | 94 |
| D-36 | 5.2 | 87 |
| D-37 | 5.1 | 86 |
| D-46 | 6.0 | 98 |
| D-47 | 6.2 | 98 |
| D-48 | 5.9 | 97 |
| D-55 | 6.2 | 98 |
| D-84 | 5.2 | 89 |
| Comparative Dye 1 | 5.9 | 74 |

Table 2 showed that the first photo-electrochemical cell containing the first dye of the present invention exhibited the photoelectric conversion efficiency equal or superior to that of the cell containing the comparative dye 1. In addition, the first cell of the present invention exhibited much superior stability to heat and light, as compared with the cell containing the comparative dye 1.

As explained above in detail, the first metal complex dye of the present invention has a high stability to heat and light, and can effectively sensitize semiconductor particles. Consequently, the first photoelectric conversion device using the first dye exhibits a high stability to heat and light and an excellent photoelectric conversion efficiency. The first photo-electrochemical cell comprising the first device of the present invention is extremely useful as a solar cell.

### EXAMPLE 2

The metal complex dye according to the invention.

### 1. Synthesis of metal complex dye

Specific methods for synthesizing the metal complex dyes D-100, D-138, D-93, D-136, D-95 and D-137 of the present invention will be explained below.

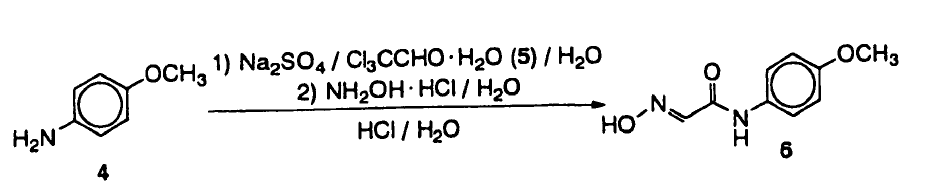

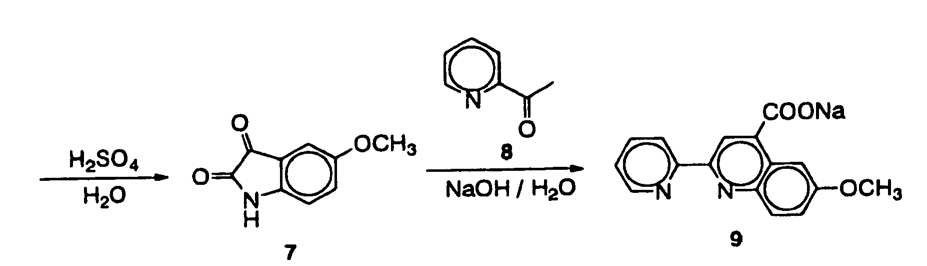

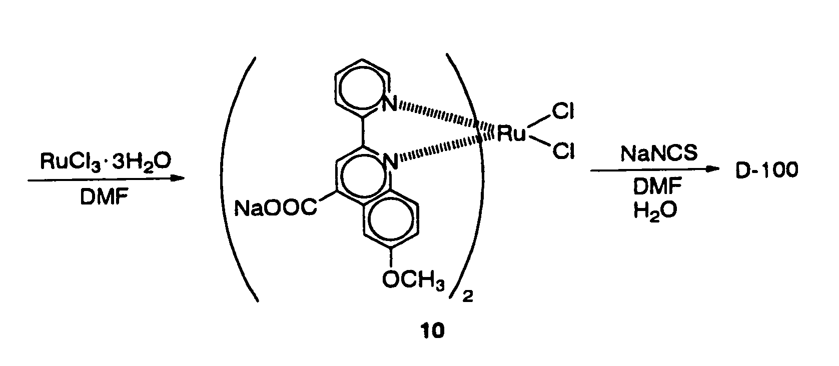

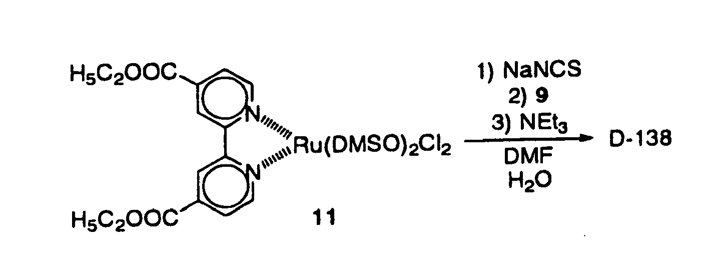

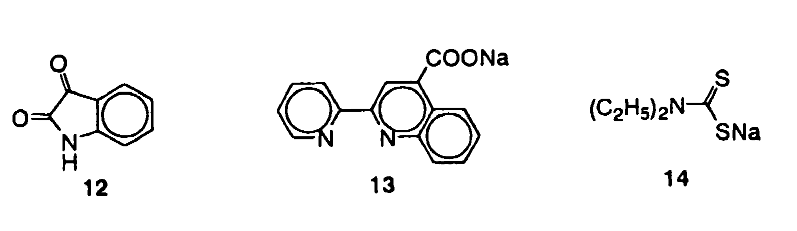

### (A) Synthesis of D-100

24.6 g (0.2 mol) of p-anisidine **4** and 20 ml of conc. HCl were dissolved in 150 ml of water, and to this was added an aqueous solution prepared by adding 39.7 g (0.24 mol) of chloral hydrate **5** and 250 g of sodium sulfate to 850 ml of water. To the resulting solution was added aqueous solution prepared by adding 49.7 g (0.71 mol) of hydroxylamine hydrochloride to 600 ml of water. After 10 minutes of reflux, the aqueous solution was cooled, filtered, and washed with water to obtain 33.7 g of oxime **6** (brown crystal, 87% yield).

17.5 g (90 mmol) of oxime **6** was dissolved in 100 ml of 90 % sulfuric acid, and the resultant solution was stirred for 10 minutes at 80 °C. The solution was cooled, stirred in 2 L of water to generate crystal, and filtered. The crystal was washed with water to obtain 5.0 g of methoxyisatin **7** (31 % yield).

To a mixture of 1.95 g (11 mmol) of methoxyisatin **7** and 1.21 g (10 mmol) of acetylpyridine **8** was added 5.5 g of NaOH 33 % aqueous solution dropwise at 5°C. The solution was stirred for 1 hour at 5 °C and for 1 hour at 60 °C, and added 10 ml of iced water to. The resultant was filtered, and washed with iced water and acetone to obtain 1.12 g of pyridylquinoline **9** (crystal, 31 % yield).

0.60 g (2 mmol) of pyridylquinoline **9** and 0.26 g (1 mmol) of ruthenium chloride trihydrate were dissolved in 15 ml of dry N,N-dimethylformamide (DMF). The solution was refluxed for 8 hours under nitrogen in the dark, and distilled under a reduced pressure. Residue was dispersed in acetonitrile and filtered to obtain 0.77 g of ruthenium complex **10** (crystal, 99% yield).

0.143 g (0.2 mmol) of ruthenium complex **10** and 0.18 g (2.2 mmol) of sodium thiocyanate were dissolved in a mixed solvent composed of 10 ml of DMF and 3 ml of water. The solution was refluxed for 6 hours under nitrogen in the dark, and distilled under reduced pressure. Residue was dissolved in water and to this was added dilute nitric acid, thereby depositing precipitates. The solution was filtered and washed with water, and residue was purified by column chromatography using Sephadex column LH-20 (developing solvent: methanol) to obtain 0.072 g of the metal complex dye D-100 (50% yield). The structure of the product was identified by NMR spectra.

### (B) Synthesis of D-138

0.12 g (0.2 mmol) of ruthenium complex **11** synthesized referring to J. Chem. Soc., Dalton, 1973, 204 and 0.032 g (2.4 mmol) of sodium thiocyanate were dissolved in a mixed solvent composed of 30 ml of N,N-dimethylformamide and 10 ml of water, and the solution was refluxed for 2 hours under nitrogen in the dark. To this was added 0.06 g (0.2 mmol) of pyridylquinoline **9,** and the resultant solution was refluxed for 6 hours and further for 6 hours after adding 15 ml of triethylamine thereto. The reaction mixture was concentrated, and residue was dissolved in methanol and purified by column chromatography using Sephadex column LH-20 (developing solvent: methanol). Fractions of desired product were concentrated, and residue was dissolved in water. To this was added dilute nitric acid for depositing crystal, and the resultant solution was filtered to obtain 0.060 g of the metal complex dye D-138 (41% yield). The structure of the product was identified by NMR spectra.

### (C) Synthesis of D-93 and D-136

Pyridylquinoline **13** was synthesized in the same manner as synthesis of pyridylquinoline **9** except for using the commercially available isatin **12** in place of methoxyisatin **7** in the same molar amount. The metal complex dye D-93 and D-136 were synthesized in the same manners as syntheses of D-100 and D-138 except for using the pyridylquinoline **13** in place of the pyridylquinoline **9,** respectively. The structures of the products were identified by NMR spectra.

### (D) Synthesis of D-95 and D-137

The metal complex dye D-95 and D-137 were synthesized in the same manners as in syntheses of D-93 and D-136 except for using sodium dithiocarbamate 14 in place of sodium thiocyanate in 1/2 molar amount, respectively. The structures of the products were identified by NMR spectra.

### (E) Syntheses of other dyes

The second metal complex dyes of the present invention other than the above-described dyes can be also easily synthesized by using suitable ligands in a similar method to above. Ligands in the second dyes of the present invention are commercially available, or can be easily synthesized referring to Synth. Commun., 27, 2165 (1997), Aust. J. Chem., 25, 1631 (1972), etc. or references therein.

### 2. Measurement of absorption spectrum

With regards to D-93, D-95, D-100, D-136, D-137, D-138 and the comparative dye 1, absorption spectra were measured. A maximum absorption wavelength and a long wavelength side absorption edge according to the dyes were shown in Table 3.

**Table 3.**

| Metal Complex Dye | Maximum Absorption Wavelength (in MeOH, nm) | Long Wavelength Side Absorption Edge (nm) |
|---|---|---|
| D-93 | 580 | 850 |
| D-95 | 605 | 900 |
| D-100 | 565 | 850 |
| D-136 | 555 | 850 |
| D-137 | 560 | 900 |
| D-138 | 550 | 840 |
| Comparative Dye 1 | 532 | 800 |

As shown in Table 3, the second metal complex dye of the present invention had a maximum absorption wavelength longer than that of the comparative dye 1. In addition, the absorption spectrum of the second dye of the present invention was broader than that of the comparative dye 1. Accordingly, the photo-electrochemical cell utilizing the second metal complex dye of the present invention can efficiently convert light in longer wavelength region into electricity as compared with a prior art metal complex dye.

### 3. Preparation of photo-electrochemical cell

The photo-electrochemical cells each comprising the second metal complex dye represented by the above general formula (II) or the comparative dye 1 were prepared in the same manner as EXAMPLE 1.

### 4. Measurement of photoelectric conversion efficiency

With respect to the photo-electrochemical cells, the photoelectric conversion efficiency to light at 800 nm was measured by IPCE (Incident Photon to Current Conversion Efficiency) measuring instrument manufactured by Optel Co. The results are shown in Table 4.

**Table 4.**

| Metal Cornplex Dye | IPCE (800nm; %) |
|---|---|
| D-93 | 7 |
| D-95 | 5 |
| D-100 | 13 |
| D-101 | 9 |
| D-103 | 21 |
| D-104 | 17 |
| D-105 | 20 |
| D-109 | 23 |
| D-112 | 8 |
| D-114 | 22 |
| D-115 | 16 |
| D-119 | 21 |
| D-120 | 14 |
| D-121 | 7 |
| D-136 | 4 |
| D-137 | 2 |
| D-138 | 6 |
| D-139 | 10 |
| Comparative Dye 1 | 0 |

As shown in Table 4, because the comparative dye 1 had no absorbability to light at 800 nm, the photo-electrochemical cell using the dye could not convert the light into electricity. As compared with this, the second photo-electrochemical cell utilizing the second dyes of the present invention exhibited an excellent photoelectric conversion efficiency to such a light having a long wavelength.

As explained above in detail, the second metal complex dye of the present invention has a high absorbability against light in a large wavelength region containing visible region to infrared region. Consequently, the second photoelectric conversion device using the second dye exhibits a high photoelectric conversion efficiency to a light in the visible region to the infrared region. The second photo-electrochemical cell comprising the second device is extremely useful as a solar cell.

## Claims

1. A metal complex dye represented by the following general formula (II):
M₂(LL₂)ₘ₃(LL₃)ₘ₄(X₂)ₘ₅ • Cl₂ (II)
wherein M₂ is Ru;
LL₂ represents a bidentate ligand represented by any one of the following general formulae (V-1), (V-3) and (V-6): 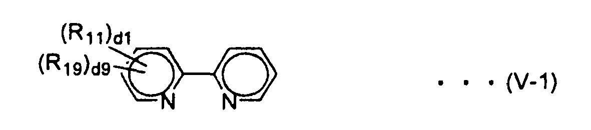 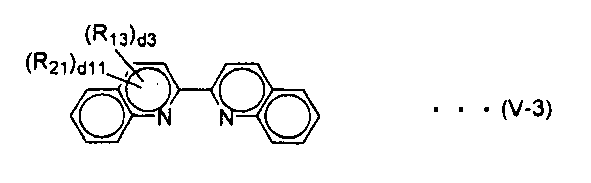 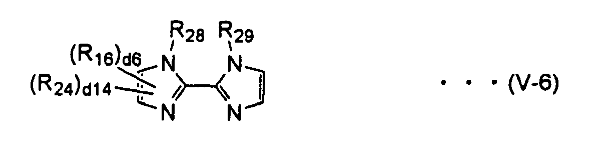 wherein R₁₁, R₁₃ and R₁₆ independently represent a carboxyl group, a sulfonic acid group, a hydroxyl group, a hydroxamic acid group, a phosphoryl group or a phosphonyl group, R₁₉, R₂₁ and R₂₄ independently represent a substituent, R₂₈ and R₂₉ independently represent an alkyl group, an alkenyl group, an aryl group or a hydrogen atom, R₁₁, R₁₃, R₁₆, R₁₉, R₂₁ and R₂₄ may be bonded to any carbon atom forming a ring, d1, d6 and d14 independently represent an integer of 0 to 4, d3 is 1 or 2, d9 and d11 independently represent an integer of 0 to 6, R₁₁, R₁₃ and R₁₆ may be the same or different groups when d1 and d6 are 2 or more and d3 is 2, and R₁₉. R₂₁ and R₂₄ may be the same or different groups that may be bonded together to form a ring when d9, d11 and d14 are 2 or more;
LL₃ represents a bidentate ligand represented by the following general formula (IV): 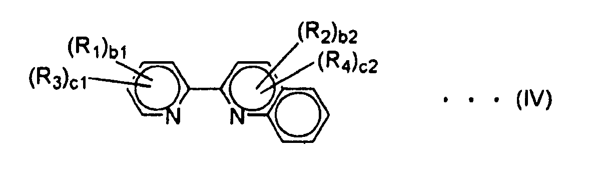 wherein R₁ and R₂ independently represent a carboxyl group, a sulfonic acid group, a hydroxyl group, a hydroxamic acid group, a phosphoryl group or a phosphonyl
group, R₃ and R₄ independently represent a substituent, b1 represents an integer of 0 to 4, b2 is 1 or 2, c1 is 0 or 1, c2 represents an integer of 0 to 5, R₁'s may be the same or different groups when b1 is 2 or more, R₂'s may be the same or different groups when b2 is 2, R₄'s may be the same or different groups that may be bonded together to form a ring when c2 is 2 or more, and R₃ and R₄ may be bonded to form a ring when c1 is 1 and c2 is 1 or more;
X₂ represents a monodentate or bidentate ligand which coordinates to M₂ via one or two groups selected from the group consisting of an acyloxy group, an acylthio group, an acylaminooxy group, a thioacyloxy group, a thioacylthio group, a thiocarbonate group, a dithiocarbonate group, a trithiocarbonate group, an alkylthio group, an arylthio group, an alkoxy group, an aryloxy group, a thiocarbamate group, a dithiocarbamate group, an acyl group, a thiocyanate group, an isothiocyanate group, a cyanate group, an isocyanate group and a cyano group, or a monodentate or bidentate ligand selected from the group consisting of ketones, carbonamides, thiocarbonamides, thioureas, isothioureas, halogen atoms and carbonyl;
m3 represents 0 or 1;
m4 represents 1 or 2, and LL₃'s may be the same or different ligands when m4 is 2;
m5 represents an integer of 0 to 2, and X₂'s may be the same or different ligands that may be bonded together when m5 is 2;
at least one of m3 and m5 is not 0; and
Cl₂ represents a counter ion optionally contained to neutralize charge of said metal complex dye.

2. The metal complex dye according to claim 1, wherein the sum of b1 and b2 in said general formula (IV) is 1 to 4.

3. The metal complex dye according to claim 1 or 2, wherein the sum of c1 and c2 is 1 to 6, and R₃ and R₄ independently represent an alkyl group, an alkenyl group, a cycloalkyl group, an alkoxy group, an aryloxy group, an acylamino group, an amino group, a hydroxyl group or an alkynyl group in said general formula (IV).

## Patentansprüche

1. Metallkomplexfarbstoff dargestellt durch die folgende allgemeine Formel (11):
M₂(LL₂)ₘ₃(LL₃)ₘ₄(X₂)ₘ₅ • Cl₂ (II)
wobei M₂ Ru ist;
LL₂ einen zweizähnigen Liganden darstellt, dargestellt durch jede der folgenden allgemeinen Formeln (V-1), (V-3) und (V-6): 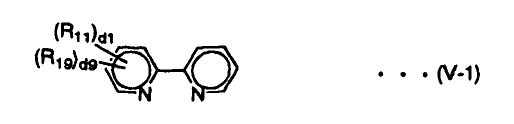 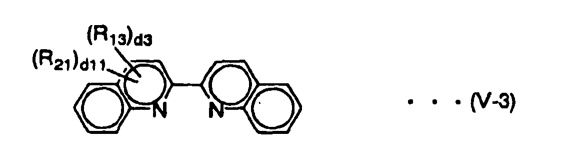 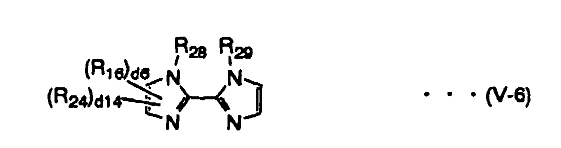 wobei R₁₁, R₁₃ und R₁₆ unabhängig eine Carboxylgruppe, eine Sulfonsäuregruppe, eine Hydroxylgruppe, eine Hydroxamsäuregruppe, eine Phosphorylgruppe oder eine Phosphonylgruppe darstellen, R₁₉, R₂₁ und R₂₂ unabhängig einen Substituenten darstellen, R₂₈ und R₂₉ unabhängig eine Alkylgruppe, eine Alkenylgruppe, eine Arylgruppe oder ein Wasserstoffatom darstellen, R₁₁, R₁₃, R₁₆, R₁₉, R₂₁ und R₂₄ mit irgendeinem Kohlenstoffatom verbunden sein können, um einen Ring zu bilden, d1, d6 und d14 unabhängig eine ganze Zahl von 0 bis 4 darstellen, d3 1 oder 2 ist, d9 und d11 unabhängig eine ganze Zahl von 0 bis 6 darstellen, R₁₁, R₁₃ und R₁₆ die gleiche oder unterschiedliche Gruppen sein können, wenn d1 und d2 2 oder mehr betragen und d3 2 ist, und R₁₉, R₂₁ und R₂₄ die gleiche oder unterschiedliche Gruppen sein können, die miteinander verbunden sein können, um einen Ring zu bilden, wenn d9, d11 und d14 2 oder mehr betragen;
LL₃ einen zweizähnigen Liganden darstellt, dargestellt durch die folgende allgemeine Formel (V1): 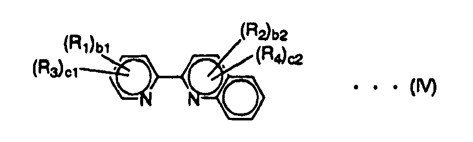 wobei R₁ und R₂ unabhängig eine Carboxylgruppe, eine Sulfonsäuregruppe, eine Hydroxylgruppe, eine Hydroxamsäuregruppe, eine Phosphorylgruppe oder eine Phosphonylgruppe darstellen, R₃ und R₄ unabhängig einen Substituenten darstellen, b1 eine ganze Zahl von 0 bis 4 darstellt, b2 1 oder 2 beträgt, c1 0 oder 1 beträgt, c2 eine ganze Zahl von 0 bis 5 darstellt, die RₗS die gleiche oder unterschiedliche Gruppen sein können, wenn b1 2 oder mehr beträgt, die R₂S die gleiche oder unterschiedliche Gruppen sein können, wenn b2 2 beträgt, die R₄S die gleiche oder unterschiedliche Gruppen sein können, die miteinander verbunden sein können, um einen Ring zu bilden, wenn c2 2 oder mehr beträgt, und R₃ und R₄ miteinander verbunden sein können, um einen Ring zu bilden, wenn c1 1 ist und c2 1 oder mehr beträgt,
X₂ einen einzähnigen oder zweizähnigen Liganden darstellt, welcher mit M₂ koordiniert ist, über eine oder zwei Gruppen ausgewählt aus der Gruppe bestehend aus einer Acyloxygruppe, einer Acylthiogruppe, einer Acylaminooxygruppe, einer Thioacylgruppe, einer Thioacylthiogruppe, einer Thiocarbonatgruppe, einer Dithiocarbonatgruppe, einer Trithiocarbonatgruppe, einer Alkylthiogruppe, einer Arylthiogruppe, einer Alkoxygruppe, einer Aryloxygruppe, einer Thiocarbamatgruppe, einer Dithiocarbamatgruppe, einer Acylgruppe, einer Thiocyanatgruppe, einer Isothiocyanatgruppe, einer Cyanatgruppe, einer Isocyanatgruppe und einer Cyanogruppe, oder ein einzähniger oder zweizähniger Ligand gewählt aus der Gruppe bestehend aus Ketonen, Carbonamiden, Thiocarbonamiden, Thioureas, lsothioureas, Halogenatomen und Carbonyl;
m3 0 oder 1 darstellt;
m4 1 oder 2 darstellt und die LL₃S die gleichen oder unterschiedliche Liganden sein können, wenn m4 2 beträgt;
m5 eine ganze Zahl von 0 bis 2 darstellt, und die X₂S die gleichen oder unterschiedliche Liganden sein können, welche miteinander verbunden sein können, wenn m5 2 beträgt;
wenigstens eines von m3 und m5 nicht 0 ist; und
Cl₂ ein Gegen-Ion darstellt, welches gegebenenfalls enthalten ist, um die Ladung des Metallkomplexfarbstoffes zu neutralisieren.

2. Metallkomplexfarbstoff nach Anspruch 1, wobei die Summe von b1 und b2 in der allgemeinen Formel (IV) 1 bis 4 beträgt.

3. Metallkomplexfarbstoff gemäß Anspruch 1 oder 2, wobei die Summe von c1 und c2 1 bis 6 beträgt, und R₃ und R₄ unabhängig eine Alkylgruppe, eine Alkenylgruppe, eine Cycloalkylgruppe, eine Alkoxygruppe, eine Aryloxygruppe, eine Acylaminogruppe, eine Amniogruppe, eine Hydroxylgruppe oder eine Alkynylgruppe in der allgemeinen Formel (V) darstellen.

## Revendications

1. Colorant de complexe de métal représenté par la formule générale (II) suivante :
M₂(LL₂)ₘ₃(LL₃)ₘ₄(X₂)ₘ₃ • Cl₂ (II)
dans laquelle M₂ est Ru ;
LL₂ représente un ligand bidenté représenté par l'une quelconque des formules générales (V-1), (V-3) et (V-6) suivantes : 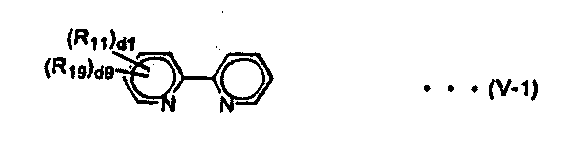 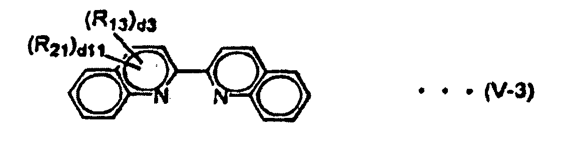 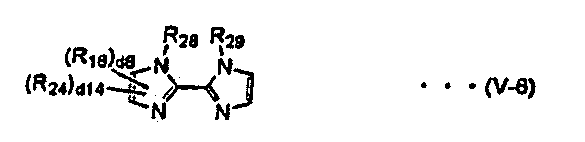 dans lesquelles R₁₁, R₁₃ et R₁₆ représentent indépendamment un groupe carboxyle, un groupe acide sulfonique, un groupe hydroxyle, un groupe acide hydroxamique, un groupe phosphoryle ou un groupe phosphonyle, R₁₉, R₂₁ et R₂₄ représentent indépendamment un substituant, R₂₈ et R₂₉ représentent indépendamment un groupe alkyle, un groupe alcényle, un groupe aryle ou un atome d'hydrogène, R₁₁, R₁₃, R₁₆, R₁₉, R₂₁ et R₂₄ peuvent être liés à un atome de carbone quelconque formant un cycle, d1, d6 et d14 représentent indépendamment un nombre entier de 0 à 4, d3 est égal à 1 ou à 2, d9 et d11 représentent indépendamment un nombre entier de 0 à 6, R_{11,} R₁₃ et R₁₆ peuvent être des groupes identiques ou différents lorsque d1 et d6 sont égaux à 2 ou plus et d3 est égal à 2, et R₁₉, R₂₁ et R₂₄ peuvent être des groupes identiques ou différents qui peuvent être liés ensemble pour former un cycle lorsque d9, d11 et d14 sont égaux à 2 ou plus ;
LL₃ représente un ligand bidenté représenté par la formule générale (IV) suivante : 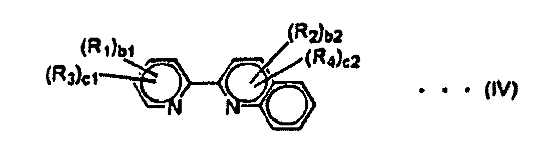 dans laquelle R₁ et R₂ représentent indépendamment un groupe carboxyle, un groupe acide sulfonique, un groupe hydroxyle, un groupe acide hydroxamique, un groupe phosphoryle ou un groupe phosphonyle,
R₃ et R₄ représentent indépendamment un substituant, b1 représente un nombre entier de 0 à 4, b2 est égal à 1 ou à 2, c1 est égal à 0 ou à 1, c2 représente un nombre entier de 0 à 5, les R₁ peuvent être des groupes identiques ou différents lorsque b1 est égal à 2 ou plus, les R₂ peuvent être des groupes identiques ou différents lorsque b2 est égal à 2, les R₄ peuvent être des groupes identiques ou différents qui peuvent être liés ensemble pour former un cycle lorsque c2 est égal à 2 ou plus, et R₃ et R₄ peuvent être liés pour former un cycle lorsque c1 est égal à 1 et c2 est égal à 1 ou plus ;
X₂ représente un ligand monodenté ou bidenté qui se coordonne à M₂ via un ou deux groupes choisis dans le groupe constitué d'un groupe acyloxy, d'un groupe acylthio, d'un groupe acylamino-oxy, d'un groupe thioacyloxy, d'un groupe thioacylthio, d'un groupe thiocarbonate, d'un groupe dithiocarbonate, d'un groupe trithiocarbonate, d'un groupe alkylthio, d'un groupe arylthio, d'un groupe alcoxy, d'un groupe aryloxy, d'un groupe thiocarbamate, d'un groupe dithiocarbamate, d'un groupe acyle, d'un groupe thiocyanate, d'un groupe isothiocyanate, d'un groupe cyanate, d'un groupe isocyanate et d'un groupe cyano, ou un ligand monodenté ou bidenté choisi dans le groupe constitué de cétones, de carbonamides, de thiocarbonamides, de thiourées, d'isothiourées, d'atomes d'halogène et d'un groupe carbonyle ;
m3 représente 0 ou 1 ;
m4 représente 1 ou 2, et les LL₃ peuvent être des ligands identiques ou différents lorsque m4 est égal à 2 ;
m5 représente un nombre entier de 0 à 2, et les X₂ peuvent être des ligands identiques ou différents qui peuvent être liés ensemble lorsque m5 est égal à 2 ;
au moins un de m3 et de m5 n'est pas égal à 0 ; et
Cl₂ représente un contre-ion éventuellement contenu pour neutraliser la charge dudit colorant de complexe de métal.

2. Colorant de complexe de métal selon la revendication 1, dans lequel la somme de b1 et de b2 dans ladite formule générale (IV) est égale à de 1 à 4.

3. Colorant de complexe de métal selon la revendication 1 ou 2, dans lequel la somme de c1 et de c2 est égale à de 1 à 6, et R₃ et R₄ représentent indépendamment un groupe alkyle, un groupe alcényle, un groupe cycloalkyle, un groupe alcoxy, un groupe aryloxy, un groupe acylamino, un groupe amino, un groupe hydroxyle ou un groupe alcynyle dans ladite formule générale (IV).
